# EUROPEAN PATENT APPLICATION

(11) **EP 4 491 648 A1**
(43) Date of publication of application: **15.01.2025**
(21) Application number: 23766366.1
(22) Date of filing: 02.02.2023
(51) Int. Cl.: C08F 293/00, C09D 7/47, C09D 153/02, C09D 201/00, G03F 7/004

(54) **COMPOUND, PRODUCTION METHOD FOR SAID COMPOUND, LEVELING AGENT, COATING COMPOSITION, RESIST COMPOSITION, AND ARTICLE**

(30) Priority: 08.03.2022 JP 2022035076
(71) Applicant: DIC Corporation, Tokyo 174-8520 (JP)
(72) Inventor: FUJIWARA Ryuta, Ichihara-shi, Chiba 290-8585 (JP); UENO Junpei, Ichihara-shi, Chiba 290-8585 (JP)
(74) Representative: TBK
(86) International application number: PCT/JP2023/003306
(87) International publication number: WO 2023/171186

(57) **Abstract**

Provided is a compound capable of functioning as a leveling agent which imparts high smoothness and the effect of suppressing pin unevenness to a coating film. Specifically, a compound includes a polymer block of a polymerizable monomer at each of both ends of a silicone chain, dispersity (Mw/Mn) which is the ratio of the weight-average molecular weight to the number-average molecular weight being within a range of 1.0 to 2.0.

## Description

### Technical Field

The present invention relates to a compound, a method for producing the compound, a leveling agent, a coating composition, a resist composition, and an article.

### Background Art

A leveling agent is an additive for improving cissing and coating unevenness of a coating film obtained by coating a coating composition such as a coating material composition, a resist composition, or the like.

Specifically, when a leveling agent is added to a coating composition, the leveling agent is aligned on the surface of a coating film and decreases surface tension of the coating film, and thus the function of smoothing the resultant coating film can be obtained. The coating film having a smoothed surface can improve the occurrence of cissing and unevenness.

The leveling agent is used for various applications, and is, for example, also used for a color resist composition used for forming a color filter for a liquid crystal display.

The production of a color filter generally includes a step of coating a color resist composition on a glass substrate by a coating method such as spin coating, slit coating, or the like, exposing to light the coating film using a mask after drying, and then developing the film to form a colored pattern. In this case, when there is unevenness of the film thickness due to poor smoothness of the coating film or when there is coating unevenness, cissing, or the like, color unevenness may occur in pixels.

The addition of the leveling agent to the color resist composition can improve the smoothness of the resultant coating film, and can exhibit high smoothness of the surfaces of red (R), green (G), and blue (B) pixels and of the black matrix (BM) formed between these pixels, and thus a color filter with little color unevenness can be obtained.

A silicone-based polymer leveling agent is proposed as the leveling agent which imparts smoothness to a coating film (Patent Literatures 1 and 2).

### Citation List

### Patent Literature

PTL 1: Japanese Unexamined Patent Application Publication No. 2018-199765
PTL 2: Japanese Unexamined Patent Application Publication No. 2002-179991

### Summary of Invention

### Technical Problem

As described above, a coating film formed by coating a coating composition, containing a leveling agent, on a substrate can exhibit high smoothness. The coating film is generally dried in a vacuum drying device for evaporating the solvent in the coating film, and the coating film on the substrate is supported by support pins and dried in a chamber of the drying device. In this case, there is a problem that a temperature difference occurs between a portion where each of the support pins is in contact with the substrate and other portions, thereby causing pin unevenness (drying unevenness) due to a difference in drying rate. The pin unevenness is hardly solved even by adding the leveling agent.

Also, in a recent coating composition, it has been required to decrease the amounts of not only impurities but also additives such as the leveling agent and the like, and there has been required a leveling agent which can exhibit the necessary leveling effect even by a small amount (for example, a solid content of 0.1% by mass or less).

A problem to be solved by the present invention is to provide a compound capable of functioning as a leveling agent which imparts high smoothness and the effect of suppressing pin unevenness to a coating film.

Another problem to be solved by the present invention is to provide a leveling agent which can impart high smoothness to a coating film and can obtain the effect of suppressing pin unevenness even by adding a small amount.

A still other problem to be solved by the present invention is to provide a coating composition and a resist composition which can impart high smoothness and the effect of suppressing pin unevenness to a coating film.

A further problem to be solved by the present invention is to provide a cured product having high smoothness and suppressed pin unevenness.

### Solution to Problem

As a result of earnest research, the inventors found that high smoothness and the effect of suppressing pin unevenness can be imparted to a coating film by a compound having a polymer block of a polymerizable monomer at each of both ends of a silicone chain and having dispersity within a specific range, leading to achievement of the present invention.

That is, the present invention relates to a compound having a living polymer block of a polymerizable monomer at each of both ends of a silicone chain.

### Advantageous Effects of Invention

The present invention can provide a compound functioning as a leveling agent which imparts high smoothness and the effect of suppressing pin unevenness to a coating film.

### Description of Embodiments

An embodiment of the present invention is described below. The present invention is not limited to the embodiment below and can be carried out by adding proper modification within a range not impairing the effect of the present invention.

In the present specification, "(meth)acrylate" represents one or both of acrylate and methacrylate.

### [Compound]

A compound of the present invention is a compound having a polymer block of a polymerizable monomer at each of both ends of a silicone chain, and dispersity (Mw/Mn), which is a ratio of weight-average molecular weight to number-average molecular weight, is within a range of 1.0 to 2.0.

Herein, "both ends of a silicone chain" represents both ends of the main chain of a silicone chain (the longest molecular chain among the molecular chains constituting a silicone chain).

The compound of the present invention is a compound having a dispersity (Mw/Mn) within a range of 1.0 to 2.0 and having a little variation of molecular weight, and thus the ratio of a molecular weight suitable for the leveling effect is relatively increased as compared with a usual compound having high dispersity. Therefore, a characteristic is obtained, in which the effect can be exhibited by a small addition amount while an addition amount is usually required for exhibiting the effect.

The number-average molecular weight of the silicone chain is, for example, within a range of 100 to 50,000, preferably within a range of 500 to 20,000, more preferably within a range of 1,000 to 15,000, and still more preferably within a range of 1,000 to 10,000.

The number-average molecular weight of the silicone chain can be measured by ²⁹Si NMR analysis.

The ratio of the silicone chain is, for example, within a range of 1% to 95% by mass, preferably within a range of 5% to 70% by mass, more preferably within a range of 10% to 65% by mass, and still more preferably within a range of 20% to 60% by mass.

The ratio of the silicone chain is a value (mass of silicone chain/mass of compound) based on the mass of the compound of the present invention. The ratio of the silicone chain is a value calculated from the charge ratio of raw materials for production, and can be adjusted by the raw material charge ratio between a silicone compound and polymerizable monomer used for producing the compound of the present invention.

The silicone chain possessed by the compound of the present invention is preferably a silicone chain represented by formula (1) below.

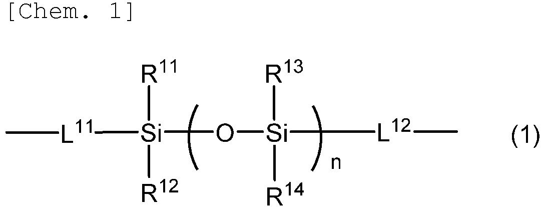

(In the formula (1),
R¹¹, R¹², R¹³, and R¹⁴ are each independently an alkyl group having 1 to 18 carbon atoms or a phenyl group.
L¹¹ and L¹² are each independently a divalent organic group or a single bond.
n is an integer.)

An alkyl group having 1 to 18 carbon atoms as each of R¹¹, R¹², R¹³, and R¹⁴ is preferably an alkyl group having 1 to 6 carbon atoms and more preferably a methyl group.

When n is an integer of 2 or more, a plurality of R¹³ may be the same or different, and a plurality of R¹⁴ may be the same or different.

The average number of n is preferably an integer within a range of 5 to 300, more preferably an integer within a range of 10 to 250, still more preferably an integer within a range of 10 to 200, and most preferably an integer within a range of 40 to 150.

The divalent organic group as each of L¹¹ and L¹² is preferably an alkylene group having 1 to 50 carbon atoms, or an alkyleneoxy group having 1 to 50 carbon atoms.

Examples of the alkylene group having 1 to 50 carbon atoms as each of L¹¹ and L¹² include a methylene group, an ethylene group, a n-propylene group, a n-butylene group, a n-pentylene group, a n-hexylene group, a n-heptylene group, a n-octylene group, a n-nonylene group, a n-decylene group, a n-dodecylene group, an isopropylene group, a 2-methylpropylene group, a 2-methylhexylene group, a tetramethylethylene group, and the like.

The alkylene group having 1 to 50 carbon atoms as each of L¹¹ and L¹² is preferably an alkylene group having 1 to 15 carbon atoms, more preferably an alkylene group having 1 to 5 carbon atoms, and still more preferably a methylene group, an ethylene group, a n-propylene group, or an isopropylene group.

The alkyleneoxy group having 1 to 50 carbon atoms as each of L¹¹ and L¹² is, for example, a group in which one or more -CH₂- in the alkylene group is substituted by -O-.

The alkyleneoxy group having 1 to 50 carbon atoms as each of L¹¹ and L¹² is preferably an alkyleneoxy group having 1 to 15 carbon atoms, more preferably an alkyleneoxy group having 1 to 8 carbon atoms, and still more preferably a methyleneoxy group, an ethyleneoxy group, a n-propyleneoxy group, an oxytrimethylene group, a butyleneoxy group, an oxytetramethylene group, a pentyleneoxy group, a heptyleneoxy group, or an octyleneoxy group.

When the divalent organic group as each of L¹¹ and L¹² is an alkylene group having 1 to 50 carbon atoms or an alkyleneoxy group having 1 to 50 carbon atoms, -CH₂- of the divalent organic group may be partially substituted by a carbonyl bond (-C(=O)-), an ester bond (-C(=O)O-), an amide bond (-C(=O)-NH-), or a phenylene group.

When the divalent organic group as each of L¹¹ and L¹² is an alkylene group having 1 to 50 carbon atoms or an alkyleneoxy group having 1 to 50 carbon atoms, a hydroxyl group or the like may be further substituted at a carbon atom.

In the formula (1), a bonding hand possessed by each of L¹¹ and L¹² is a bonding hand bonded to the polymer block of a polymerizable monomer directly or through a linking group.

With respect to the polymer block of a polymerizable monomer possessed by the compound of the present invention, the "polymerizable monomer" represents a compound having a polymerizable unsaturated group, and the "polymer block" represents a segment having a repeating structure derived from the polymerizable monomer.

Examples of the polymerizable unsaturated group include a (meth)acryloyl group, a(meth)acryloyloxy group, a (meth)acryloylamino group, a vinyl ether group, an allyl group, a styryl group, a maleimide group, and the like. Among these, in view of easy availability of raw materials and good polymerization reactivity, a (meth)acryloyl group and a (meth)acryloyloxy group are preferred.

The polymer block of the polymerizable monomer possessed by the compound of the present invention is preferably a polymer block of a polymerizable monomer (2) which can exhibit compatibility with a base polymer of a coating composition.

The polymerizable monomer (2) is preferably a polymerizable monomer having one or more selected from an alkyl group having 1 to 18 carbon atoms, an aromatic group having 6 to 18 carbon atoms, a group containing a polyoxyalkylene chain, and a group containing a polyester chain.

An alkyl group having 1 to 18 carbon atoms possessed by the polymerizable monomer (2) may be any one of a linear alkyl group, a branched alkyl group, and a cyclic alkyl group, and examples thereof include a methyl group, an ethyl group, a normal propyl group, an isopropyl group, a n-butyl group, a tert-butyl group, a n-hexyl group, a cyclohexyl group, a n-octyl group, a hexadecyl group, and the like.

The alkyl group having 1 to 18 carbon atoms possessed by the polymerizable monomer (2) is preferably an alkyl group having 1 to 6 carbon atoms.

Examples of the aromatic group having 6 to 18 carbon atoms possessed by the polymerizable monomer (2) include a phenyl group, a naphthyl group, an anthracen-1-yl group, a phenathren-1-yl, and the like.

The group containing a (poly)oxyalkylene chain possessed by the polymerizable monomer (2) is a monovalent group containing an oxyalkylene repeating portion or a divalent linking group containing an oxyalkylene repeating portion.

When the polymerizable unsaturated group possessed by the polymerizable monomer (2) is a (meth)acryloyl group, the polymerizable monomer having a group containing a (poly)oxyalkylene chain is, for example, a compound represented by formula (2-poa1) or (2-poa2) below and is preferably a compound represented by the formula (2-poa1).

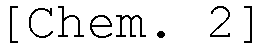

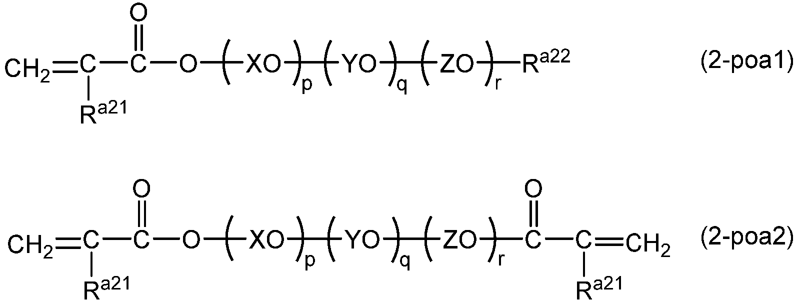

(In the formulae (2-poa1) and (2-poa2),
R^{a21} are each independently a hydrogen atom or a methyl group.
R^{a22} is a hydrogen atom or an alkyl group having 1 to 18 carbon atoms.
p is an integer of 0 or more, q is an integer of 0 or more, r is an integer of 0 or more, and p + q + r is an integer of 1 or more.
X, Y, and Z are each independently an alkylene group having 1 to 6 carbon atoms.)

In the formulae (2-poa1) and (2-poa2), a group represented by -(XO)ₚ-(YO)_{q}-(ZO)ᵣ-R^{a22} and a group represented by -(XO)ₚ-(YO)_{q}-(ZO)ᵣ- each correspond to a group containing a (poly)oxyalkylene chain.

In the formulae (2-poa1) and (2-poa2), an alkylene group having 1 to 6 carbon atoms as each of X. Y, and Z is preferably an alkylene group having 2 o 4 carbon atoms.

Examples of the polymerizable monomer (2) having an alkyl group having 1 to 18 carbon atoms and a (meth)acryloyl group as the polymerizable unsaturated group include (meth)acrylic acid alkyl esters having 1 to 18 carbon atoms, such as methyl (meth)acrylate, ethyl (meth)acrylate, n-propyl (meth)acrylate, isopropyl (meth)acrylate, n-butyl (meth)acrylate, s-butyl (meth)acrylate, isobutyl (meth)acrylate, tert-butyl(meth)acrylate, n-pentyl (meth)acrylate, n-hexyl (meth)acrylate, n-heptyl (meth)acrylate, n-octyl (meth)acrylate, 2-ethylhexyl (meth)acrylate, decyl (meth)acrylate, dodecyl (meth)acrylate, stearyl (meth)acrylate, isostearyl (meth)acrylate, and the like; (meth)acrylic acid crosslinked cyclic alkyl esters having 1 to 18 carbon atoms, such as dicyclopentanyloxyl ethyl (meth)acrylate, isobornyloxyl ethyl (meth)acrylate, isobornyl (meth)acrylate, adamantyl (meth)acrylate, dimethyl adamantyl (meth)acrylate, dicyclopentanyl (meth)acrylate, dicyclopentenyl (meth)acrylate, and the like; and the like.

Examples of the polymerizable monomer (2) having a phenylalkyl group having 7 to 18 carbon atoms or a phenoxyalkyl group having 7 to 18 carbon atoms and a (meth)acryloyl group as the polymerizable unsaturated group include benzyl (meth)acrylate, phenoxymethyl (meth)acrylate, 2-phenoxyethyl (meth)acrylate, and the like.

Examples of the polymerizable monomer (2) having a alkyl group having 1 to 18 carbon atoms and a vinyl ether group as the polymerizable unsaturated group include alkyl vinyl ethers such as methyl vinyl ether, ethyl vinyl ether, n-propyl vinyl ether, isopropyl vinyl ether, n-butyl vinyl ether, isobutyl vinyl ether, tert-butyl vinyl ether, n-pentyl vinyl ether, n-hexyl vinyl ether, n-octyl vinyl ether, n-dodecyl vinyl ether, 2-ethylhexyl vinyl ether, cyclohexyl vinyl ether, and the like; cycloalkyl vinyl ether; and the like.

Examples of the polymerizable monomer (2) having an aromatic group having 6 to 18 carbon atoms include styrene, α-methylstyrene, p-methylstyrene, p-methoxystyrene, and the like.

Examples of the polymerizable monomer (2) having an alkyl group having 1 to 18 carbon atoms and a (meth)acryloylamino group as the polymerizable unsaturated group include N,N-dimethylacrylamide, N,N-diethylacrylamide, N-isopropylacrylamide, diacetone acrylamide, acryloylmorpholine, and the like.

Examples of the polymerizable monomer (2) having an alkyl group having 1 to 18 carbon atoms and a maleimide group as the polymerizable unsaturated group include methyl maleimide, ethyl maleimide, propyl maleimide, butyl maleimide, hexyl maleimide, octyl maleimide, dodecyl maleimide, stearyl maleimide, cyclohexyl maleimide, and the like.

Examples of the polymerizable monomer (2) having a group containing a polyoxyalkylene chain and a (meth)acryloyl group as the polymerizable unsaturated group include polypropylene glycol mono(meth)acrylate, polyethylene glycol mono(meth)acrylate, polytrimethylene glycol mono(meth)acrylate, polytetramethylene glycol mono(meth)acrylate, poly(ethylene glycol-propylene glycol) mono(meth)acrylate, polyethylene glycol-polypropylene glycol mono(meth)acrylate, poly(ethylene glycol-tetramethylene glycol) mono(meth)acrylate, polyethylene glycol-polytetramethylene glycol mono(meth)acrylate, poly(propylene glycol-tetramethylene glycol) mono(meth)acrylate, polypropylene glycol-polytetramethylene glycol mono(meth)acrylate, poly(propylene glycol-1,2-butylene glycol) mono(meth)acrylate, polypropylene glycol-poly-1,2-butylene glycol mono(meth)acrylate, poly(ethylene glycol-1,2-butylene glycol) mono(meth)acrylate, polyethylene glycol-poly-1,2-butylene glycol mono(meth)acrylate, poly(tetraetylene glycol-1,2-butylene glycol) mono(meth)acrylate, polytetraethylene glycol-poly-1,2-butylene glycol mono(meth)acrylate, poly-1,2-butylene glycol mono(meth)acrylate, poly(ethylene glycol-trimethylene glycol) mono(meth)acrylate, polyethylene glycol-polytrimethylene glycol mono(meth)acrylate, poly(propylene glycol-trimethylene glycol) mono(meth)acrylate, polypropylene glycol-polytrimethylene glycol mono(meth)acrylate, poly(trimethylene glycol-tetramethylene glycol) mono(meth)acrylate, polytrimethylene glycol-polytetramethylene glycol mono(meth)acrylate, poly(1,2-buylene glycol-trimethylene glycol) mono(meth)acrylate, poly-1,2-butylene glycol-polytrimethylene glycol mono(meth)acrylate, 2-hydroxyethyl (meth)acrylate, 2-hydroxypropyl (meth)acrylate, 2-hydroxybutyl (meth)acrylate, 4-hydroxybutyl (meth)acrylate, poly(1,2-butylene glycol-tetramethylene glycol) mono(meth)acrylate, poly-1,2-buylene glycol-polytetramethylene glycol mono(meth)acrylate, and the like.

The "poly(ethylene glycol-propylene glycol)" described above represents a random copolymer of ethylene glycol and propylene glycol, and the "polyethylene glycol-polypropylene glycol" represents a block copolymer of ethylene glycol and propylene glycol.

The polymerizable monomer (2) is preferably one or more selected from the group consisting of a compound represented by formula (2-1) below, a compound represented by formula (2-2) below, a compound represented by formula (2-3) below, a compound represented by formula (2-4) below, and a compound represented by formula (2-5) below, and more preferably one or more selected from the group consisting of a compound represented by formula (2-1) below, a compound represented by formula (2-2) below, a compound represented by formula (2-3) below, and a compound represented by formula (2-4) below.

These compounds can exhibit high compatibility when a polymer of the present invention is used as the leveling agent.

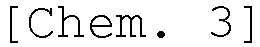

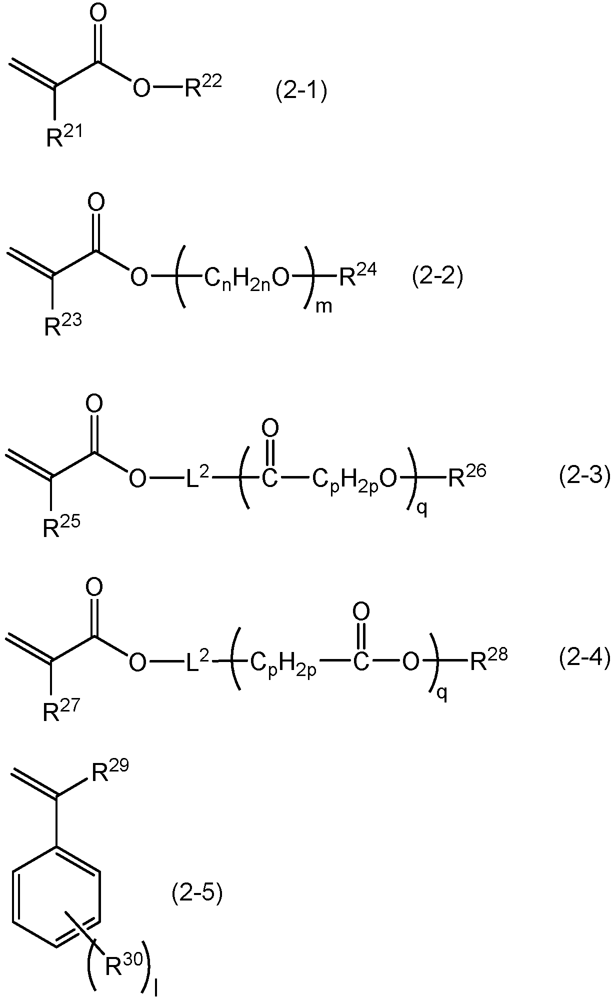

(In the formulae (2-1), (2-2), (2-3), (2-4), and (2-5),
R²¹ is a hydrogen atom or a methyl group;
R²² is an alkyl group having 1 to 18 carbon atoms;
R²³ is a hydrogen atom or a methyl group;
R²⁴ is a hydrogen atom or an alkyl group having 1 to 18 carbon atoms;
R²⁵ is a hydrogen atom or a methyl group;
R²⁶ is an alkyl group having 1 to 18 carbon atoms or an alkyl group having 1 to 18 carbon atoms and an ether bond;
R²⁷ is a hydrogen atom or a methyl group;
R²⁸ is an alkyl group having 1 to 18 carbon atoms or an alkyl group having 1 to 18 carbon atoms and an ether bond;
L² isa divalent organic group or a single bond;
R²⁹ is a hydrogen atom or a methyl group;
R³⁰ are each independently an alkyl group having 1 to 6 carbon atoms or an alkoxy group having 1 to 6 carbon atoms;
n is an integer within a range of 1 to 4; m is an integer within a range of 1 to 200; p is an integer within a range of 1 to 10; q is an integer within a range of 1 to 100; and l is an integer within a range of 0 to 5.)

In the formula (2-2), n in m parentheses may be the same or different.

In the formula (2-3), p in q parentheses may be the same or different.

In the formula (2-4), p in q parentheses may be the same or different.

Examples of the divalent organic group as L² in the formulae (2-3) and (2-4) include the same as those of the divalent organic group as L¹¹.

The polymerizable monomer (2) preferably contains one or more selected from the group consisting of a compound represented by the formula (2-2), a compound represented by the formula (2-3), and a compound represented by the formula (2-4) .

When one or more selected from the group consisting of a compound represented by the formula (2-2), a compound represented by the formula (2-3), and a compound represented by the formula (2-4) are contained as the polymerizable monomer (2), the total amount of the compound represented by the formula (2-2), the compound represented by the formula (2-3), and the compound represented by the formula (2-4) is preferably 50% by mass or more relative to the total amount of the polymerizable monomer (2).

The polymerizable monomer (2) can be produced by a known method.

Also, a commercial product may be used as the polymerizable monomer (2). Examples of a commercial product of the polymerizable monomer (2) having a group containing a polyoxyalkylene chain and a (meth)acryloyl group as the polymerizable unsaturated group include "NK Ester M-20G", "NK Ester M-40G", "NK Ester M-90G", "NK Ester M-230G", "NK Ester AM-90G", "NK Ester AMP-10G", "NK Ester AMP-20G", and "NK Ester AMP-60G" manufactured by Shin-Nakamura Chemical Co., Ltd., "*Blemmer* PE-90", "Blemmer PE-200", "Blemmer PE-350", "Blemmer PME-100", "Blemmer PME-200", "Blemmer PME-400", "Blemmer PME-4000", "Blemmer PP-1000", "Blemmer PP-500", "Blemmer PP-800", "Blemmer 70PEP-350B", "Blemmer 55PET-800", "Blemmer 50POEP-800B", "Blemmer 10PPB-500B", "Blemmer NKH-5050", "Blemmer AP-400", and "Blemmer AE-350" manufactured by NOF Corporation, Placcel F series manufactured by Daicel Corporation, Viscort series manufactured by Osaka Organic Chemical Industry, Ltd., and the like.

In the polymer block of the polymerizable monomer possessed by the compound of the present invention, the polymerizable monomer constituting the polymer block may be a single polymerizable monomer or two or more polymerizable monomers.

When the polymer block is a copolymer of two or more polymerizable monomers, the polymerization type of the copolymer is not particularly limited and may be a random copolymer of two or more polymerizable monomers having different structures or may be a block copolymer of two or more polymerizable monomers having different structures.

The number-average molecular weight (Mn) of the compound of the present invention is preferably within a range of 1,000 to 200,000, more preferably within a range of 1,500 to 50,000, and still more preferably within a range of 2,000 to 20,000.

The weight-average molecular weight (Mw) of the compound of the present invention is preferably within a range of 1,000 to 400,000, more preferably within a range of 2,000 to 100,000, and still more preferably within a range of 4,000 to 40,000.

The values of number-average molecular weight (Mn) and the weight-average molecular weight (Mw) of the compound of the present invention are measured by a method described in examples.

The dispersity (Mw/Mn) of the compound of the present invention is within a range of 1.0 to 2.0, preferably within a range of 1.0 to 1.8, and more preferably within a range of 1.0 to 1.6.

In order to adjust the dispersity within the range describe above, living radical polymerization described later is required to be performed for producing the compound, and so-called free radical polymerization cannot bring the dispersity into the range described above.

### [Method for producing compound]

The compound of the present invention can be produced by generating radicals from a compound (1) having a functional group having the radical generating ability at each of both ends of a silicone chain in a reaction system containing the compound (1) and the polymerizable monomer (2), and performing living radical polymerization of the polymerizable monomer (2) at each of both ends of the compound (1).

The number-average molecular weight (Mn) of the silicone chain possessed by the compound (1) is, for example, within a range of 100 to 50,000, preferably within a range of 500 to 20,000, more preferably within a range of 1,000 to 15,000, and still more preferably within a range of 1,000 to 10,000.

Examples of the functional group having the radical generating ability possessed by the compound (1) include a halogen atom-containing organic group, an alkyltellurium group-containing organic group, a dithioester group-containing organic group, a peroxide group-containing organic group, an azo group-containing organic group, and the like.

From the viewpoint of the ease of synthesis, the ease of polymerization control, and the diversity of polymerizable monomers which can be applied, the functional group having the radical generating ability possessed by the compound (1) is preferably a halogen atom-containing organic group.

Examples of the halogen atom-containing organic group include organic groups including 2-bromo-2-methylpropionyloxy group, 2-bromo-propionyloxy group, a parachlorosulfonyl benzoyloxy group, and the like.

The compound (1) having the functional group having the radical generating ability at each of both ends of the silicone chain preferably a compound represented by formula (1-1) below.

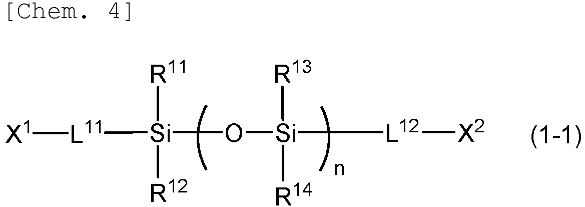

(In the formula (1-1),
R¹¹, R¹², R¹³, and R¹⁴ are each independently an alkyl group having 1 to 18 carbon atoms or a phenyl group.
L¹¹ and L¹² are each independently a divalent organic group or a single bond.
n is an integer.
X¹ and X² are each independently a functional group having the radical generating ability.)

In the formula (1-1), the preferred forms of R¹¹, R¹², R¹³, R¹⁴, L¹¹, L¹², and n are the same as the preferred forms of R¹¹, R¹², R¹³, R¹⁴, L¹¹, L¹², and n of the formula (1) .

In the formula (1-1), the functional group having the radical generating ability as each of X¹ and X² is, for example, a halogen atom-containing organic group and preferably a functional group represented by formula (X-1) below.

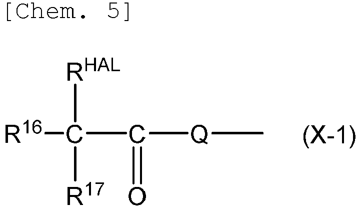

(In the formula (X-1),
R^{HAL} is a halogen atom.
R¹⁶ and R¹⁷ are each independently an alkyl group having 1 to 6 carbon atoms.
Q is an oxygen atom or a sulfur atom.)

A specific example of the compound (1) having the functional group having the radical generating ability at each of both ends of the silicone chain is a compound below.

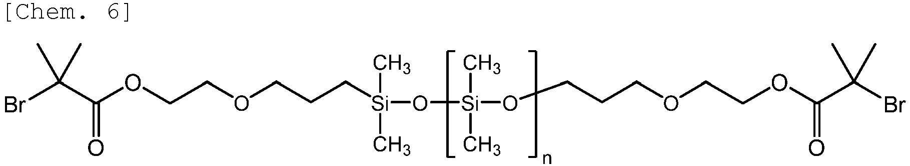

(In the formula, n is an integer.)

The compound (1) having the functional group having the radical generating ability at each of both ends of the silicone chain can be produced by a known method.

The polymerizable monomer (2) used in a method for producing the compound of the present invention is the same as the polymerizable monomer (2) described for the compound of the present invention, and polymerizable monomers may be used alone or in combination of two or more.

The reaction raw materials used for the method for producing the compound of the present invention are not limited to only the compound (1) having the functional group having the radical generating ability at each of both ends of the silicone chain and the polymerizable monomer (2), and another monomer other than the compound (1) and the polymerizable monomer (2) may be used within a range not impairing the effect of the present invention.

Examples of the other monomer include hydroxyalkyl (meth)acrylate, para-vinylbenzoic acid, N-phenyl maleimide, and the like. The other monomers used as reaction raw materials may be used alone or in combination of two or more.

The charge ratio between the compound (1) having the functional group having the radical generating ability at each of both ends of the silicone chain and the polymerizable monomer (2) is not particularly limited, but the mass ratio (compound (1)/polymerizable monomer (2)) is, for example, 1/99 to 99/1, preferably 5/95 to 80/20, and more preferably 10/90 to 70/30.

In the living radical polymerization, a dormant species having an active polymerization terminal protected by an atom or atom group reversibly generates radical and reacts with a monomer, and thus growth rection proceeds. Even when a first monomer is consumed, the growth terminal does not lose reactivity and reacts with a sequentially added second monomer, thereby enabling to form a block polymer. Examples of the living radical polymerization include atom transfer radical polymerization (ATRP), reversible addition/fragmentation radical polymerization (RAFT), nitroxide-mediated radical polymerization (NMP), organotellurium-mediated radical polymerization (TERP), and the like. Which of these methods is used is not particularly limited, but ATRP is preferred because of the ease of control. ATRP is polymerization using an organic halide or sulfonyl halide compound as a polymerization initiator and a metal complex, containing a transition metal compound and a ligand, as a catalyst.

In the method for producing the compound of the present invention, the compound (1) can function as a polymerization initiator and permits living radical polymerization of the polymerizable monomer (2) with the compound (1).

The transition metal compound which can be used for ATRP is represented by Mⁿ⁺Xₙ.

The transition metal Mⁿ⁺ of the transition metal compound represented by Mⁿ⁺Xₙ can be selected from the group consisting of Cu⁺, Cu²⁺, Fe²⁺, Fe³⁺, Ru²⁺, Ru³⁺, Cr²⁺, Cr³⁺, Mo⁰, Mo⁺, Mo²⁺, Mo³⁺, W²⁺, W³⁺, Rh³⁺, Rh⁴⁺, Co⁺, Co²⁺, Re²⁺, Re³⁺, Ni⁰, Ni⁺, Mn³⁺, Mn⁴⁺, V²⁺, V³⁺, Zn⁺, Zn²⁺, Au⁺, Au²⁺, Ag⁺, and Ag²⁺.

X of the transition metal compound represented by Mⁿ⁺Xₙ can be selected from the group consisting of a halogen atom, an alkoxyl group having 1 to 6 carbon atoms, (SO₄)_{1/2}, (PO₄)_{1/3}, (HPO₄)_{1/2}, (H₂PO₄), triflate, hexafluorophosphate, methane sulfonate, aryl sulfonate (preferably, benzene sulfonate or toluene sulfonate), SeR¹¹, CN, and R¹²COO. Herein, R¹¹ represents an aryl group, or a linear or branched alkyl group having 1 to 20 carbon atoms (preferably 1 to 10 carbon atoms), and R¹² represents a hydrogen atom or a linear or branched alkyl group having 1 to 6 carbon atoms (preferably a methyl group) which may be substituted by halogen 1 to 5 times (preferably substituted by fluorine or chlorine 1 to 3 times).

n of the transition metal compound represented by Mⁿ⁺Xₙ represents the formal charge on a metal and is an integer of 0 to 7.

Examples of a ligand compound which can be coordinate-bonded to the transition metal of the transition metal compound include a compound having a ligand which can be coordinated to a transition metal through σ bond and contains one or more nitrogen atoms, oxygen atoms, phosphorus atoms, or sulfur atoms, a compound having a ligand which can be coordinated to a transition metal through π bond and contains two or more carbon atoms, and a compound having a ligand which can be coordinated to a transition metal through µ bond or η bond.

The transition metal complex is not particularly limited, but is preferably a complex of a group 7, 8, 9, 10, or 11 transition metal, and more preferably a complex of 0-valent copper, monovalent copper, divalent ruthenium, divalent iron, or divalent nickel.

Specific examples of the catalyst which can be used for ATRP, when the center metal is copper, include complexes with ligands such as 2,2'-bipyridyl and derivatives thereof, 1,10-phenanthroline and derivatives thereof, polyamines such as tetramethyl ethylenediamine, pentamethyl diethylene triamine, hexamethyl tris(2-aminoethyl)amine, tris[2-dimethylamino]ethyl]amine, tris(2-pyridylmethyl)amine, and the like. Examples of a divalent ruthenium complex include dichlorotris(triphenylphosphine)ruthenium, dichlorotris(tributylphosphine)ruthenium, dichloro(cyclooctadiene)ruthenium, dichlorobenzene ruthenium, dichloro-p-cymene ruthenium, dichloro(norbornadiene)ruthenium, cis-dichlorobis(2,2'-bipyridine)ruthenium, dichlorotris(1,10-phenanthroline)ruthenium, carbonyl chlorohydride tris(triphenylphosphine)ruthenium, and the like. Examples of a divalent iron complex include a bistriphenylphosphine complex, a triazacyclononane complex, and the like.

The atom transfer radical polymerization (ATRP) is not limited to the above, and ATRP other than the above can be performed. For example, AGET ATRP, ARGET ATRP, ICAR ATRP, and the like, described in "Macromol. Rapid. Commun. 2018, 1800616", can also be used.

The living radical polymerization is preferably performed by using a solvent.

Examples of the solvent used in the living radical polymerization include ester-based solvents such as ethyl acetate, butyl acetate, propylene glycol monomethyl ether acetate, and the like; ether-based solvents such as diisopropyl ether, dimethoxyethane, diethylene glycol dimethyl ether, and the like; halogen-based solvents such as dichloromethane, dichloroethane, and the like; aromatic solvents such as toluene, xylene, anisole, and the like; ketone-based solvents such as methyl ethyl ketone, methyl isobutyl ketone, cyclohexanone, and the like; alcohol-based solvents such as methanol, ethanol, isopropanol, and the like; aprotic polar solvents such as dimethylformamide, dimethyl sulfoxide, and the like; and the like.

The solvents may be used alone or in combination of two or more.

The polymerization temperature of the living radical polymerization is preferably within a range of room temperature to 120°C.

When the compound of the present invention is produced by living radical polymerization, a metal derived from the transition metal compound used in polymerization may remain in the resultant compound. The metal remaining in the resultant polymer may be removed by using activated alumina or the like after the completion of polymerization.

### [Coating composition]

The compound of the present invention can be preferably used as a leveling agent for a coating composition, and the coating composition of the present invention contains the compound of the present invention. The compound of the present invention can be used as a fluorine atom-free leveling agent not containing fluorine atom, and thus the leveling agent has low accumulation in the environment and small environmental load.

The content of the compound of the present invention contained in the coating composition of the present invention depends on the type of the base resin, the coating method, the intended film thickness, etc., but is, for example, 0.001 to 10 parts by mass, preferably 0.01 to 5 parts by mass, more preferably 0.02 to 2 parts by mass, and still more preferably 0.02 to 1 part by mass relative to 100 parts by mass of the solid content of the coating composition.

The leveling effect can be exhibited even by a small amount of the compound of the present invention, and the occurrence of a defect, such as foaming or the like, during coating can be suppressed.

Application of the coating composition of the present invention is not particularly limited, and the coating composition can be used in any application as long as the leveling property is required in the application. The coating composition of the present invention can be used as, for example, various coating material compositions and photosensitive resin compositions.

When the coating composition of the present invention is used as a composition for a coating material, examples of the composition for a coating material include coating materials using natural resins, such as a petroleum resin coating material, a shellac coating material, a rosin-based coating material, a cellulose-based coating material, a rubber-based coating material, a lacquer coating material, a *cashew* resin coating material, an oily vehicle coating material, and the like; coating materials using synthetic resins, such as a phenol resin coating material, an alkyd resin coating material, an unsaturated polyester resin coating material, an amino resin coating material, an epoxy resin coating material, a vinyl resin coating material, an acrylic resin coating material, a polyurethane resin coating material, a silicone resin coating material, a fluorine resin coating material, and the like; and the like.

The addition of the compound of the present invention to the composition for a coating material can impart smoothness to the resultant coating film.

If required, the following can be properly added to the composition for a coating material: a colorant such as a pigment, a dye, carbon, or the like; an inorganic powder such as silica, titanium oxide, zinc oxide, aluminum oxide, zirconium oxide, calcium oxide, calcium carbonate, or the like; an organic fine powder such as a higher fatty acid, a polyacrylic resin, polyethylene, or the like; and various additives such as a light-resistant improver, a weather-resistant improver, a heat-resistant improver, an antioxidant, a thickener, an anti-settling agent, and the like.

Any coating method can be used as a coating method for the coating composition of the present invention as long as it is a known usual coating method, and examples thereof include methods such as a slit coater, a slit & spin coater, a spin coater, a roll coater, electrostatic coating, a bar coater, a gravure coater, a die coater, a knife coater, ink jet, dipping coating, spray coating, shower coating, screen printing, gravure printing, offset printing, reverse coating, and the like.

The photosensitive resin composition is a composition in which the physical properties of the resin, such as solubility, viscosity, transparency, refractive index, conductivity, ion permeability, etc., are changed by irradiation with light such as visible light, ultraviolet light, or the like.

Among the photosensitive resin compositions, a resist composition (a photoresist composition, a color resist composition for a color filter, or the like) is required to have a high degree of leveling property. The resist composition is generally coated on a silicon wafer or a glass substrate, on which various metals are vapor-deposited, by spin coating so that the thickness is about 1 2 um. In this case, fluctuation in thickness of the coating film or the occurrence of coating unevenness decreases pattern linearity and reproductivity and thus causes the problem of failing to obtain a resist pattern having intended precision. Also, besides this problem, there are various problems with leveling, such as dropping marks, overall unevenness, a bead phenomenon in which an edge portion is thickened as compared with a central portion, etc.

The problems can be solved by using the coating composition of the present invention as a resist composition because the compound of the present invention can exhibit a high degree of leveling property and can form a uniform coating film (cured product).

When the coating composition of the present invention is used as a photoresist composition, the photoresist composition contains, other than the compound of the present invention, an alkali-soluble resin, a radiation-sensitive material (photosensitive material), a solvent, etc.

The alkali-soluble resin contained in the photoresist composition is a resin soluble in an alkaline solution used as a developing solution used for resist patterning.

Examples of the alkali-soluble resin include a novolac resin obtained by condensation of an aromatic hydroxyl compound derivative such as phenol, cresol, xylenol, resorcinol, fluoroglycinol, hydroquinone, or the like with an aldehyde compound such as formaldehyde, acetaldehyde, benzaldehyde, or the like; a polymer or copolymer of a vinyl phenol compound derivative such as o-vinyl phenol, m-vinyl phenol, p-vinyl phenol, α-methyl vinyl phenol, or the like; a polymer or copolymer of a (meth)acrylic acid compound such as acrylic acid, methacrylic acid, hydroxymethyl (meth)acrylate, or the like; polyvinyl alcohol; a modified resin in which a radiation-sensitive group, such as a quinonediazide group, a naphthoquinonediazide group, an aromatic diazide group, an aromatic cinnamoyl group, or the like, is introduced through some of the hydroxyl groups of any one of these resins; a urethane resin containing an acid group such as a carboxylic acid, sulfonic acid, or the like in the molecule thereof; and the like.

These alkali-soluble resins may be used alone or in combination of two or more.

The radiation-sensitive material contained in the photoresist composition is a material which changes the solubility of the alkali-soluble resin in the developing solution by irradiation with active energy rays such as ultraviolet light, far-ultraviolet light, excimer laser, X-rays, electron beams, ion beams, molecular beams, γ-rays, or the like.

Examples of the radiation-sensitive material include a quinonediazide-based compound, a diazo-based compound, an azide-based compound, an onium salt compound, a halogenated organic compound, a mixture of a halogenated organic compound and an organic metal compound, an organic acid ester compound, an organic acid amide compound, an organic acid imide compound, a poly(olefin sulfone)compound, and the like.

Examples of the quinonediazide-based compound include 1,2-benzoquinoneazide-4-sulfonate ester, 1,2-naphthoquinonediazide-4-sulfonate ester, 1,2-naphthoquinonediazide-5-sulfonate ester, 2,1-naphthoquinonediazide-4-sulfonate ester, 2,1-naphthoquinonediazide-5-sulfonate ester, quinonediazide derivative sulfonic acid chlorides such as 1,2-benzoquinoneazide-4-sulfonic acid chloride, 1,2-naphthoquinonediazide-4-sulfonic acid chloride, 1,2-naphthoquinonediazide-5-sulfonic acid chloride, 2,1-naphthoquinonediazide-4-sulfonic acid chloride, 2,1-naphthoquinonediazide-5-sulfonic acid chloride, and the like.

Examples of the diazo-based compound include a salt of condensate of p-diazodiphenylamine and formaldehyde or acetaldehyde, a diazo resin inorganic salt which is the reaction product of a hexafluorophosphate salt, a tetrafluoroborate salt, a perchlorate salt, or a periodate salt with the condensate, a diazo resin organic salt which is the reaction product of the condensate with sulfonic acids as described in the specification of USP No. 3,300,309, and the like.

Examples of the azide-based compound include azidochalconic acid, diazidobenzal methyl cyclohexanones, azidocinnamylidene acetophenones, aromatic azide compounds, aromatic diazide compounds, and the like.

Examples of the halogenated organic compound include a halogen-containing oxadiazole-based compound, a halogen-containing triazine-based compound, a halogen-containing acetophenone-based compound, a halogen-containing benzophenone-based compound, a halogen-containing sulfoxide-based compound, a halogen-containing sulfone-based compound, a halogen-containing thiazole-based compound, a halogen-containing oxazole-based compound, a halogen-containing triazole-based compound, a halogen-containing 2-pyrone-based compound, a halogen-containing aliphatic hydrocarbon-based compound, a halogen-containing aromatic hydrocarbon-based compound, a halogen-containing heterocyclic compound, a sulfenyl halide-based compound, and the like.

Besides the above, examples of the halogenated organic compound include compounds used as halogen-based flame retardants, such as tris(2,3-dibromopropyl) phosphate, tris(2,3-dibromo-3-chloropropyl) phosphate, chlorotetrabromomethane, hexachlorobenzene, hexabromobenzene, hexabromocyclododecane, hexabromobiphenyl, tribromophenyl allyl ether, tetrachlorobisphenol A, tetrabromobisphenol A, bis(bromoethyl ether) tetrabromobisphenol A, bis(chloroethyl ether) tetrachlorobisphenol A, tris(2,3-dibromopropyl) isocyanurate, 2,2-bis(4-hydroxy-3,5-dibromophenyl) propane, 2,2-bis(4-hydroxyethoxy-3,5-dibromophenyl) propane, and the like, compounds used as organic chloro-based agricultural chemicals, such as dichlorophenyl trichloroethane, and the like, and the like.

Examples of the organic acid ester include a carboxylate ester, a sulfonate ester, and the like. Examples of the organic acid amide include carboxylic acid amide, sulfonic acid amide, and the like. Examples of the organic acid imide include carboxylic acid imide, sulfonic acid imide, and the like.

The radiation-sensitive materials may be used alone or in combination of two or more.

The content of the radiation-sensitive material in the photoresist composition is preferably within a range of 10 to 200 parts by mass and more preferably within a range of 50 to 150 parts by mass relative to 100 parts by mass of the alkali-soluble resin.

Examples of the solvent for the photoresist composition include ketones such as acetone, methyl ethyl ketone, cyclohexanone, cyclopentanone, cycloheptanone, 2-heptanone, methyl isobutyl ketone, butyrolactone, and the like, alcohols such as methanol, ethanol, n-propyl alcohol, isopropyl alcohol, n-butyl alcohol, iso-butyl alcohol, tert-butyl alcohol, pentanol, heptanol, octanol, nonanol, decanol, and the like; ethers such as ethylene glycol dimethyl ether, ethylene glycol diethyl ether, dioxane, and the like; alcohol ethers such as ethylene glycol monomethyl ether, ethylene glycol monoethyl ether, ethylene glycol monopropyl ether, propylene glycol monomethyl ether, propylene glycol monoethyl ether, propylene glycol monopropyl ether, and the like; esters such as ethyl formate, propyl formate, butyl formate, methyl acetate, ethyl acetate, butyl acetate, propyl acetate, methyl propionate, ethyl propionate, propyl propionate, butyl propionate, methyl butyrate, ethyl butyrate, butyl butyrate, propyl butyrate, ethyl lactate, butyl lactate, and the like, monocarboxylate esters such as methyl 2-oxypropionate, ethyl 2-oxypropionate, propyl 2-oxypropionate, butyl 2-oxypropionate, methyl 2-methoxypropionate, ethyl 2-methoxypropionate, propyl 2-methoxypropionate, butyl 2-methoxypropionate, and the like; cellosolve esters such as cellosolve acetate, methyl cellosolve acetate, ethyl cellosolve acetate, propyl cellosolve acetate, butyl cellosolve acetate, and the like; propylene glycols such as propylene glycol, propylene glycol monomethyl ether, propylene glycol monomethyl ether acetate, propylene glycol monoethyl ether acetate, propylene glycol monobutyl ether acetate, and the like; diethylene glycols such as diethylene glycol monomethyl ether, diethylene glycol monoethyl ether, diethylene glycol dimethyl ether, diethylene glycol diethyl ether, diethylene glycol methyl ethyl ether, and the like; halogenated hydrocarbons such as trichloroethylene, a freon solvent, HCFC, HFC, and the like; completely fluorinated solvents such as perfluorooctane and the like, aromatics such as toluene, xylene, and the like; polar solvents such as dimethyl acetyamide, dimethyl formamide, N-methyl acetamide, N-methyl pyrrolidone, and the like.

These solvents may be used alone or in combination of two or more.

When the coating composition of the present invention is used as a color resist composition, the color resist composition contains, other than the compound of the present invention, an alkali-soluble resin, a polymerizable compound, a coloring agent, etc.

Usable examples of the alkali-soluble resin contained in the color resist include the same as the examples of the alkali-soluble resin contained in the photoresist composition described above.

The polymerizable compound contained in the color resist composition is a compound having a photopolymerizable functional group capable of polymerization or crosslinking reaction by, for example, irradiation with active energy rays such as ultraviolet light or the like.

Examples of the polymerizable compound include unsaturated carboxylic acids such as (meth)acrylic acid and the like, esters of a monohydroxy compounds and unsaturated carboxylic acids, esters of aliphatic polyhydroxy compounds and unsaturated carboxylic acids, esters of aromatic polyhydroxy compounds and unsaturated carboxylic acids, esters obtained by esterification reaction of unsaturated carboxylic acids, polyvalent carboxylic acids, and polyvalent hydroxy compounds such as the aliphatic polyhydroxy compounds, the aromatic polyhydroxy compounds, or the like, a polymerizable compound having a urethane skeleton obtained by reaction of a polyisocyanate compound and a (meth)acryloyl group-containing hydroxy compound, a polymerizable compound having an acid group, and the like.

The polymerizable compounds may be used alone or in combination of two or more.

Examples of the esters of aliphatic polyhydroxy compounds and unsaturated carboxylic acids include (meth)acrylate esters such as ethylene glycol di(meth)acrylate, triethylene glycol di(meth)acrylate, trimethylolpropane tri(meth)acrylate, trimethylolethane tri(meth)acrylate, pentaerythritol di(meth)acrylate, pentaerythritol tri(meth)acrylate, pentaerythritol tetra(meth)acrylate, dipentaerythritol tetra(meth)acrylate, dipentaerythritol penta(meth)acrylate, dipentaerythritol hexa(meth)acrylate, glycerol (meth)acrylate, and the like.

The examples also include itaconate esters, crotonate esters, and maleate esters, which are produced by substituting the (meth)acrylic acid portions of these acrylates with itaconic acid, crotonic acid, and maleic acid, respectively, and the like.

Examples of the esters of aromatic polyhydroxy compounds and unsaturated carboxylic acids include hydroquinone di(meth)acrylate, resorcine di(meth)acrylate, pyrogallol tri(meth)acrylate, and the like.

The ester obtained by esterification reaction of an unsaturated carboxylic acid, a polyvalent carboxylic acid, and a polyvalent hydroxy compound may be a single material or a mixture. Examples of the ester include an ester obtained from (meth)acrylic acid, phthalic acid, and ethylene glycol, an ester obtained by (meth)acrylic acid, maleic acid, and diethylene glycol, an ester obtained from (meth)acrylic acid, terephthalic acid, and pentaerythritol, an ester obtained from (meth)acrylic acid, adipic acid, butanediol, and glycerin, and the like.

Examples of the polymerizable compound having a urethane skeleton and produced by reaction of a polyisocyanate compound and a (meth)acryloyl group-containing hydroxy compound include the reaction product of aliphatic diisocyanate such as hexamethylene diisocyanate, trimethylhexamethylene diisocyanate, or the like; alicyclic diisocyanate such as cyclohexane diisocyanate, isophorone diisocyanate, or the like; or aromatic diisocyanate such as tolylene diisocyanate, diphenylmethane diisocyanate, or the like, and a hydroxy compound having a (meth)acryloyl group such as 2-hydroxyethyl (meth)acrylate, 3-hydroxy[1,1,1-tri(meth)acryloyloxymethyl] propane, or the like.

The polymerizable compound having an acid group is, for example, an ester of an aliphatic polyhydroxy compound and an unsaturated carboxylic acid, and is preferably a polyfunctional polymerizable compound imparted with an acid group by reacting an unreacted hydroxyl group of an aliphatic polyhydroxy compound with nonaromatic carboxylic anhydride. The aliphatic polyhydroxy compound used for preparing the polyfunctional polymerizable compound is preferably pentaerythritol or dipentaerythritol.

Because developability, curability, etc. are improved, the acid value of the polyfunctional polymerizable compound is preferably within a range of 0.1 to 40 and more preferably within a range of 5 to 30. When two or more polyfunctional polymerizable compounds having an acid group are used in combination and when a polyfunctional polymerizable compound having an acid group and a polyfunctional polymerizable compound not having an acid group are used in combination, the acid value of the mixture of the polyfunctional polymerizable compounds is preferably adjusted to fall within the range described above.

Examples of the polymerizable compound having an acid group include dipentaerythritol hexaacrylate, and a mixture of dipentaerythritol pentaacrylate and dipentaerythritol pentaacrylate succinate ester as main components, and the mixture is commercially available as Aronix TO-1382 (manufactured by Toagosei Co., Ltd.).

Examples of the polymerizable compound other than the above compounds include (meth)acrylamide such as ethylene bis(meth)acrylamide and the like; allyl esters such as diallyl phthalate and the like; compounds having a vinyl group such as divinyl phthalate and the like; and the like.

The content of the polymerizable compound in the color resist composition is preferably within a range of 5% to 80% by mass, more preferably within a range of 10% to 70% by mass, and still more preferably within a range of 20% to 50% by mass, in the total solid content of the color resist composition.

The coloring agent of the color resist composition is not particularly limited as long as it is capable of coloring, and it may be, for example, a pigment or a dye.

Any one of an organic pigment and an inorganic pigment can be used as the pigment. Usable examples of the organic pigment include pigments of respective hues, such as a red pigment, a green pigment, a blue pigment, a yellow pigment, a violet pigment, an orange pigment, a brown pigment, and the like. Also, examples of the chemical structure of the organic pigment include an azo type, a phthalocyanine type, a quinacridone type, a benzimidazolone type, an isoindolinone type, a dioxazine type, an indanthrene type, a perylene type, and the like. Examples of the inorganic pigment include barium sulfate, lead sulfate, titanium oxide, yellow lead, bengala, chromium oxide, and the like.

In addition, "C. I." described below represents Color Index.

Examples of the red pigment include C. I. Pigment Red 1, 2, 3, 4, 5, 6, 7, 8, 9, 12, 14, 15, 16, 17, 21, 22, 23, 31, 32, 37, 38, 41, 47, 48, 48:1, 48:2, 48:3, 48:4, 49, 49:1, 49:2, 50:1, 52:1, 52:2, 53, 53:1, 53:2, 53:3, 57, 57:1, 57:2, 58:4, 60, 63, 63:1, 63:2, 64, 64:1, 68, 69, 81, 81:1, 81:2, 81:3, 81:4, 83, 88, 90:1, 101, 101:1, 104, 108, 108:1, 109, 112, 113, 114, 122, 123, 144, 146, 147, 149, 151, 166, 168, 169, 170, 172, 173, 174, 175, 176, 177, 178, 179, 181, 184, 185, 187, 188, 190, 193, 194, 200, 202, 206, 207, 208, 209, 210, 214, 216, 220, 221, 224, 230, 231, 232, 233, 235, 236, 237, 238, 239, 242, 243, 245, 247, 249, 250, 251, 253, 254, 255, 256, 257, 258, 259, 260, 262, 263, 264, 265, 266, 267, 268, 269, 270, 271, 272, 273, 274, 275, 276, and the like. Among these, C. I. Pigment Red 48:1, 122, 168, 177, 202, 206, 207, 209, 224, 242, or 254 is preferred, and C. I. Pigment Red 177, 209, 224, or 254 is more preferred.

Examples of the green pigment include C. I. Pigment Green 1, 2, 4, 7, 8, 10, 13, 14, 15, 17, 18, 19, 26, 36, 45, 48, 50, 51, 54, 55, 58, and the like. Among these, C. I. Pigment Green 7, 36, or 58 is preferred.

Examples of the blue pigment include C. I. Pigment Blue 1, 1:2, 9, 14, 15, 15:1, 15:2, 15:3, 15:4, 15:6, 16, 17, 19, 25, 27, 28, 29, 33, 35, 36, 56, 56:1, 60, 61, 61:1, 62, 63, 66, 67, 68, 71, 72, 73, 74, 75, 76, 78, 79, and the like. Among these, C. I. Pigment Blue 15, 15:1, 15:2, 15:3, 15:4, or 15:6 is preferred, and C. I. Pigment Blue 15:6 is more preferred.

Examples of the yellow pigment include C. I. Pigment Yellow 1, 1:1, 2, 3, 4, 5, 6, 9, 10, 12, 13, 14, 16, 17, 24, 31, 32, 34, 35, 35:1, 36, 36:1, 37, 37:1, 40, 41, 42, 43, 48, 53, 55, 61, 62, 62:1, 63, 65, 73, 74, 75,81, 83, 87, 93, 94, 95, 97, 100, 101, 104, 105, 108, 109, 110, 111, 116, 117, 119, 120, 126, 127, 127:1, 128, 129, 133, 134, 136, 138, 139, 142, 147, 148, 150, 151, 153, 154, 155, 157, 158, 159, 160, 161, 162, 163, 164, 165, 166, 167, 168, 169, 170, 172, 173, 174, 175, 176, 180, 181, 182, 183, 184, 185, 188, 189, 190, 191, 191:1, 192, 193, 194, 195, 196, 197, 198, 199, 200, 202, 203, 204, 205, 206, 207, 208, and the like. Among these, C. I. Pigment Yellow 83, 117, 129, 138, 139, 150, 154, 155, 180, or 185 is preferred, and C. I. Pigment Yellow 83, 138, 139, 150, or 180 is more preferred.

Examples of the violet pigment include C. I. Pigment Violet 1, 1:1, 2, 2:2, 3, 3:1, 3:3, 5, 5:1, 14, 15, 16, 19, 23, 25, 27, 29, 31, 32, 37, 39, 42, 44, 47, 49, 50, and the like. Among these, C. I. Pigment Violet 19 or 23 is preferred, and C. I. Pigment Violet 23 is more preferred.

Examples of the orange pigment include C. I. Pigment Orange 1, 2, 5, 13, 16, 17, 19, 20, 21, 22, 23, 24, 34, 36, 38, 39, 43, 46, 48, 49, 61, 62, 64, 65, 67, 68, 69, 70, 71, 72, 73, 74, 75, 77, 78, 79, and the like. Among these, C. I. Pigment Orange 38 or 71 is preferred.

The pixels of the three primary colors of a color filter used in a liquid crystal display device and an organic EL display device are red (R), green (G), and blue (B), and thus the red pigment, the green pigment, and the blue pigment are used as main components. In addition, an organic pigment of a color such as yellow, violet, orange, or the like may be used for hue adjustment for the purpose of improving color reproducibility.

In order to enhance brightness of a color liquid crystal display device and an organic EL display device, the average particle diameter of the organic pigment is preferably 1 um or less, more preferably 0.5 um or less, and still more preferably 0.3 um or less. The organic pigment is preferably dispersed so as to have the average particle diameter described above and then used.

The average primary particle diameter of the organic pigment is preferably 100 nm or less, more preferably 50 nm or less, still more preferably 40 nm or less, and particularly preferably within a range of 10 to 30 nm.

The average particle diameter of the organic pigment is measured by a dynamic light scattering particle size distribution analyzer, and can be measured by, for example, Nanotrac particle size distribution measuring device "UPA-EX150", "UPA-EX250", or the like manufactured by Nikkiso Co., Ltd.

When the color resist composition is used for forming a black matrix (BM), the coloring agent is not particularly limited as long as it is black, and examples thereof include carbon black, lamp black, acetylene black, bone black, thermal black, channel black, furnace black, graphite, iron black, titanium black, and the like. Among these, carbon black and titanium black are preferred from the viewpoint of light shielding rate and image characteristics.

Also, two or more organic pigments may be used in combination as a mixture to form a mixed black color.

Examples of a commercial product of the carbon black include MA7, MA8, MA11, MA100, MA100R, MA220, MA230, MA600, #5, #10, #20, #25, #30, #32, #33, #40, #44, #45, #47, #50, #52, #55, #650, #750, #850, #950, #960, #970, #980, #990, #1000, #2200, #2300, #2350, #2400, #2600, #3050, #3150, #3250, #3600, #3750, #3950, #4000, #4010, OIL 7B, OIL 9B, OIL 11B, OIL 30B, OIL 31B, and the like, which are manufactured by Mitsubishi Chemical Corporation, Printex 3, Printex 3OP, Printex 30, Printex 30OP, Printex 40, Printex 45, Printex 55, Printex 60, Printex 75, Printex 80, Printex 85, Printex 90, Printex A, Printex L, Printex P, Printex U, Printex V, Printex G, Special Black 550, Special Black 350, Special Black 250, Special Black 100, Special Black 6, Special Black 5, Special Black 4, Color Black FW1, Color Black FW2, Color Black FW2V, Color Black FW18, Color Black FW200, Color Black S160, Color Black S170, and the like, which are manufactured by Evonik Degussa Japan Co., Ltd., Monarch 120, Monarch 280, Monarch 460, Monarch 800, Monarch 880, Monarch 900, Monarch 1000, Monarch 1100, Monarch 1300, Monarch 1400, Monarch 4630, REGAL 99, REGAL 99R, REGAL 415, REGAL 415R, REGAL 250, REGAL 250R, REGAL 330, REGAL 400R, REGAL 55R0, REGAL 660R, BLACK PEARLS 480, PEARLS 130, VULCAN XC72R, ELFTEX-8, and the like, which are manufactured by Cabot Corporation, and RAVEN 11, RAVEN 14, RAVEN 15, RAVEN 16, RAVEN 22, RAVEN 30, RAVEN 35, RAVEN 40, RAVEN 410, RAVEN 420, RAVEN 450, RAVEN 500, RAVEN 780, RAVEN 850, RAVEN 890H, RAVEN 1000, RAVEN 1020, RAVEN 1040, RAVEN 1060U, RAVEN 1080U, RAVEN 1170, RAVEN 1190U, RAVEN 1250, RAVEN 1500, RAVEN 2000, RAVEN 2500U, RAVEN 3500, RAVEN 5000, RAVEN 5250, RAVEN 5750, RAVEN 7000, and the like, which are manufactured by Colombian Carbon Co., Ltd.

Among the carbon black described above, carbon black coated with a resin is preferred as having a high optical density and high surface resistivity required for the black matrix of the color filter.

Examples of a commercial product of the titanium black include Titanium Black 10S, 12S, 13R, 13M, 13M-C, and the like which are manufactured by Mitsubishi Materials Corporation.

A coloring agent used for forming the black matrix (BM) may be black formed as a mixed color by mixing two or more organic pigments, and is, for example, a black pigment prepared by mixing the three-color pigments of red, green, and blue.

Examples of a color material which can be used and mixed for preparing a black pigment include *Victoria Pure Blue* (C. I. 42595), Auramine O (C. I. 41000), Cathilon Brilliant flavin (Basic 13), Rhodamine 6GCP (C. I. 45160), Rhodamine B (C. I. 45170), Safranine OK70:100 (C. I. 50240), Erioglaucin X (C. I. 42080), No. 120/Lionol Yellow (C. I. 21090), Lionol *Yellow* GRO (C. I. 21090), Symuler Fast *Yellow* 8GF (C. I. 21105), Benzidine *Yellow* 4T-564D (C. I. 21095), Symuler Fast Red 4015 (C. I. 12355), Lionol Red 7B4401 (C. I. 15850), Fastogen Blue TGR-L (C. I. 74160), Lionol Blue SM (C. I. 26150), Lionol Blue ES (C. I. Pigment Blue 15:6), Lionogen Red GD (C. I. Pigment Red 168), Lionol Green 2YS (C. I. Pigment Green 36), and the like.

Examples of other color materials which can be used and mixed for preparing a black pigment include C. I. Yellow Pigment 20, 24, 86, 93, 109, 110, 117, 125, 137, 138, 147, 148, 153, 154, and 166, C. I. Orange Pigment 36, 43, 51, 55, 59, and 61, C. I. Red Pigment 9, 97, 122, 123, 149, 168, 177, 180, 192, 215, 216, 217, 220, 223, 224, 226, 227, 228, and 240, C. I. Violet Pigment1 19, 23, 29, 30, 37, 40, and 50, C. I. Blue Pigment 15, 15:1, 15:4, 22, 60, and 64, C. I. Green Pigment 7, C. I. Brown Pigment 23, 25, and 26, and the like.

When carbon black is used as a black pigment, the average primary particle diameter of carbon black is preferably within a range of 0.01 to 0.08 um, and because of good developability, the diameter is more preferably within a range of 0.02 to 0.05 µm.

Unlike the particle shape of an organic pigment or the like, the carbon black is present in a state called "structure" in which primary particles are fused to each other, and fine pores may be formed in the particle surfaces by post treatment. Therefore, in order to indicate the particle shape of carbon black, besides the average particle diameter of primary particles determined by the same method as for the organic pigment, the DBP absorption amount (JIS K6221) and the specific surface area according to the BET method (JIS K6217) are preferably measured as indexes of the structure and pore amount.

The dibutyl phthalic acid (abbreviated as "DBP" hereinafter) absorption amount of carbon black is preferably within a range of 40 to 100 cm³/100 g, and because of good dispersibility and developability, it is more preferably within a range of 50 to 80 cm³/100 g. The specific surface area of carbon black according to the BET method is preferably within a range of 50 to 120 m²/g, and because of good dispersion stability, it is more preferably within a range of 60 to 95 m²/g.

Examples of a dye serving as the coloring agent for the color resist composition include an azo-based dye, an anthraquinone-based dye, a phthalocyanine-based dye, a quinoneimine-based dye, a quinoline-based dye, a nitro-based dye, a carbonyl-based dye, a methine-based dye, and the like.

Examples of the azo-based dye include C. I. Acid Yellow 11, C. I. Acid Orange 7, C. I. Acid Red 37, C. I. Acid Red 180, C. I. Acid Blue 29, C. I. Direct Red 28, C. I. Direct Red 83, C. I. Direct Yellow 12, C. I. Direct Orange 26, C. I. Direct Green 28, C. I. Direct Green 59, C. I. Reactive Yellow 2, C. I. Reactive Red 17, C. I. Reactive Red 120, C. I. Reactive Black 5, C. I. Disperse Orange 5, C. I. Disperse Red 58, C. I. Disperse Blue 165, C. I. Basic Blue 41, C. I. Basic Red 18, C. I. Mordant Red 7, C. I. Mordant Yellow 5, C. I. Mordant Black 7, and the like.

Examples of the anthraquinone-based dye include C. I. Vat Blue 4, C. I. Acid Blue 40, C. I. Acid Green 25, C. I. Reactive Blue 19, C. I. Reactive Blue 49, C. I. Disperse Red 60, C. I. Disperse Blue 56, C. I. Disperse Blue 60, and the like.

Examples of the phthalocyanine-based dye include C. I. Vat Blue 5 and the like, examples of the quinoneimine-based dye include C. I. Basic Blue 3, C. I. Basic Blue 9, and the like, examples of the quinoline-based dye include C. I. Solvent Yellow 33, C. I. Acid Yellow 3, C. I. Disperse Yellow 64, and the like, and examples of the nitro-based dye include C. I. Acid Yellow 1, C. I. Acid Orange 3, C. I. Disperse Yellow 42, and the like.

In view of the excellent light resistance, weather resistance, and fastness of the resultant coating film, a pigment is preferably used as the coloring agent of the color resist composition, but if required, a dye may be used in combination with a pigment for adjusting hue.

The content of the coloring agent in the color resist composition is preferably 1% by mass or more, more preferably within a range of 5% to 80% by mass, and still more preferably within a range of 5% to 70% by mass in the total solid content of the color resist composition.

When the color resist composition is used for forming pixels of each of red (R), green (G), and blue (B) in a color filter, the content of the coloring agent in the color resist composition is preferably within a range of 5% to 60% by mass and more preferably within a range of 10% to 50% by mass in the total solid content of the color resist composition.

When the color resist composition is used for forming the black matrix of a color filter, the content of the coloring agent in the color resist composition is preferably within a range of 20% to 80% by mass and more preferably within a range of 30% to 70% by mass in the total solid content of the color resist composition.

When the coloring agent in the color resist composition is the pigment, a pigment dispersion liquid prepared by dispersing the pigment in an organic solvent using a dispersant is preferably used.

Examples of the dispersant include a surfactant; a pigment intermediate or derivative; a dye intermediate or derivative; resin-type dispersants such as a polyamide-based resin, a polyurethane-based resin, a polyester-based resin, an acrylic resin, and the like; and the like. Among these, a nitrogen atom-containing graft copolymer, a nitrogen atom-containing acrylic block copolymer, a urethane resin dispersant, and the like are preferred. These dispersants have a nitrogen atom and thus the nitrogen atom has affinity for the pigment surfaces, while the portion other than the nitrogen atom enhances affinity for the medium, thereby improving dispersion stability.

These dispersants may be used alone or in combination of two or more.

Examples of a commercial product of the dispersant include "Efka" series ("Efka 46" and the like) manufactured by BASF Corporation; "Disper byk" series and "BYK" series ("BYK-160", "BYK-161", "BYK-2001", and the like) manufactured by BYK Chemie Japan KK; "Solsperse" series manufactured by Lubrizol Corporation; "KP" series manufactured by Shin-Etsu Chemical Co., Ltd., "Polyflow" series manufactured by Kyoseisha Chemical Co., Ltd.; "Disparlon" series manufactured by Kusumoto Chemicals, Ltd.; "Ajisper" series ("Ajisper PB-814" and the like) manufactured by Ajinomoto Fine-Techno Co., Inc., and the like.

Examples of the organic solvent used for preparing the pigment dispersion liquid include acetate ester-based solvents such as propylene glycol monomethyl ether acetate, propylene glycol monoethyl ether acetate, and the like; propionate-based solvents such as ethoxy propionate and the like; aromatic solvents such as toluene, xylene, methoxybenzene, and the like; ether-based solvents such as butyl cellosolve, propylene glycol monomethyl ether, diethylene glycol ethyl ether, diethylene glycol dimethyl ether, and the like; ketone-based solvents such as methyl ethyl ketone, methyl isobutyl ketone, cyclohexanone, and the like; aliphatic hydrocarbon-based solvents such as hexane and the like; nitrogen compound-based solvents such as N,N-dimethyl formamide, γ-butyrolactam, N-methyl-2-pyrrolidone, and the like; lactone-based solvents such as γ-butyrolactone and the like; carbamate esters; and the like.

These solvents may be used alone or in combination of two or more.

Examples of a method for preparing the pigment dispersion liquid include a method including a coloring agent kneading-dispersing step and a fine dispersing step, a method including only a fine dispersing step, and the like. In the kneading-dispersing step, the coloring agent, a portion of the alkali-soluble resin, and, if required, the dispersant are mixed and kneaded. The coloring agent can be dispersed by dispersion using a kneader while applying a strong shear force.

Examples of a machine used for kneading include a two-roll mill, a three-roll mill, a ball mill, a Tron mill, Disper, a kneader, a co-kneader, a homogenizer, a blender, a single-screw or twin-screw extruder, and the like.

Before the kneading, the particle size of the coloring agent is preferably miniaturized by a salt milling method or the like.

In the fine dispersing step, a mixture prepared by adding a solvent to a composition containing the coloring agent and obtained by the kneading and dispersing step or a mixture containing the coloring agent, the alkali-soluble resin, the solvent, and, if required, the dispersant is mixed and dispersed by using a disperser together with a fine particle medium for dispersion, such as glass, zirconia, or ceramic. In this step, the particles of the coloring agent can be dispersed to a fine state close to the primary particles.

From the viewpoint of improving the transmittance, contrast, etc. of the color filter, the average particle diameter of the primary particles of the coloring agent is preferably 10 to 100 nm and more preferably 10 to 60 nm. The average particle diameter of the coloring agent is measured by a dynamic light scattering particle size distribution analyzer, and can be measured by, for example, Nanotrac particle size distribution measuring device "UPA-EX150", "UPA-EX250", or the like manufactured by Nikkiso Co., Ltd.

The composition for a coating material, the photoresist composition, and the color resist composition are exemplified above as the coating composition, but the coating composition is not limited to these.

Examples of application of the coating composition of the present invention include an anti-glare (AG: anti-glare) hard coating material, an antireflection (LR) coating material, a low-refractive-index layer coating material, a high-refractive-index layer coating material, a clear hard coating material, and a polymerizable liquid crystal coating material, which are coating materials for various display screens, such as a liquid crystal display (abbreviated as "LCD" hereinafter), a plasma display (abbreviated as "PDP" hereinafter), an organic EL display (abbreviated as "OLED" hereinafter), a quantum dot display (abbreviated as "QDD" hereinafter), and the like; a color resist, an ink jet ink, a printing in, or a coating material for forming pixels of each of RGB and the like of a color filter (abbreviated as "CF" hereinafter) of LCD or the like; a black resist, an ink jet ink, a printing ink, or a coating material for forming a black matrix, a black column spacer, and a black photo-spacer of CF of LCD or the like; a coating material for a transparent protective film for protecting the CF surface used in CF of LCD or the like; a liquid crystal material, a column spacer, and a resin composition for a photo-spacer of LCD; a resin composition for pixel partitions, a positive photoresist for forming electrodes, a protective film, an insulating film, a plastic casing, a coating material for a plastic casing and a bezel (frame) ink of LCD, PDP, OLED, QDD, or the like; a prism sheet as a backlight member, and a light diffusion film of LCD; a coating material for an organic insulating film of a liquid crystal TFT array of LCD; an internal polarizing plate surface protection coating material of LCD; a phosphor of PDP; an organic EL material and a sealing material (a protective film or a gas barrier) of OLED; a quantum dot ink, a sealing material, and a protective film of QDD; a high-refractive-index lens, a low-refractive-index seal, and LED pixels of a micro (mini) LED display; a positive photoresist, a chemical amplification type photoresist, an antireflection film, a multilayer material (SOC, SOG), a lower layer film, a buffer coat, a developer, a rinsing liquid, a pattern collapse preventing agent, a polymer residue removing liquid, a chemical liquid such as a cleaning liquid and the like, and a nanoimprint release agent, which are used for producing a semiconductor; resin compositions for a semiconductor post-process or a printed wiring board (resin compositions such as an epoxy resin, a phenol resin, a polyphenylene ether resin, a liquid crystal polymer, a polyimide resin, a bismaleimide resin, a bisallylnadic imide resin, a benzoxazine resin, and the like), a copper-clad laminate, a resin-coated copper foil, a build-up film, a passivation film, an interlayer insulating film, a flexible copper-clad laminate, and a dry film resist; a color resist for an image sensor; a liquid repellent for a solder flux; a dispersant, a coating material, and a green sheet for a multilayer ceramic capacitor; a cathode material, an anode material, a separator, and an electrolytic solution for a lithium ion battery; an exterior coating material, rubber, an elastomer, glass, a vapor deposition material anchor coat, a head lamp lens, a solid lubricating coating material, a heat radiation substrate, an interior coating material, and a repair coating material for automobile; wall paper, a floor material, a kitchen member, and a bathroom/toil member for housing equipment; an ink jet ink, an offset printing ink, a gravure printing ink, a screen printing ink, a photoresist for a printing plate producing process, a photosensitive material for a planographic printing plate (PS plate), a package adhesive, and an a ballpoint pen ink for printed matter; a primer for plastic film easy adhesion or the like; a water repellent for fibers; a non-diffusion agent for grease; a cleaning solution for cleaning the surfaces of various products or components; a hard coating material for optical recording media such as CD, DVD, a blue-ray disc, and the like; a coating material or hard coating material for a casing or screen for a smartphone or cellular phone; a hard coating material for a transfer film for insert molding (IMD, IMF); a release film; a coating material or coat material for various plastic molded products such as a casing of a home appliance and the like; a printing ink or coating material for various building materials such as a decorative laminated sheet and the like; a coating material for a window glass of housing; a coating material for woodworking for furniture and the like; a coating material for artificial/synthetic leather; a coating material for a rubber roller for OA apparatuses such as a copying machine, a printer, and the like; a coating material for reading part glass of OA apparatuses such as a copying machine, a scanner, and the like; optical lenses such as a camera, a video camera, glasses, a contact lens, and the like or a coating material therefor; a windshield and a coating material for glass of watches such as wrist watch and the like; a coating material for windows of various vehicles such as automobile, a railroad vehicle, and the like; a coating material for an antireflection film of a cover glass or film for a solar cell; a coating material or coat material for a FRP bath; PCM for a metallic building material or a home appliance; a single layer or multilayer coating composition for a photofabrication process and the like; and the like.

The compound of the present invention has the excellent ability to reduce surface tension, and thus not only the leveling property but also various functions such as wettability, permeability, washability, water repellency, oil repellency, antifouling property, lubricity, antiblocking property, mold releasability, etc. can be expected. Also, when the compound of the present invention is mixed with a coating material or coating agent containing fine particles, dispersibility of the fine particles can be improved, and not only the leveling property but also the function as a dispersant for the fine particles can be expected. In addition, when the compound of the present invention is added to an adhesive composition used for an adhesive tape or the like other than the coating composition, not merely the leveling property but also various functions of decreasing the peeling force, suppressing variation in the peeling force, and suppressing peeling charge can be expected.

### EXAMPLES

The present invention is specifically described below by examples and comparative examples.

In addition, the present invention is not limited to the examples below.

In the examples and the comparative examples, the weight-average molecular weight (Mw) and number-average molecular weight (Mn) are values in terms of polystyrene based on gel permeation chromatography (GPC) measurement.

The measurement conditions of GPC are as follows.

### [GPC measurement conditions]

Measurement apparatus: high-speed GPC apparatus "HLC-8420GPC" manufactured by Tosoh Corporation
Column: "TSK GUARDCOLUMN SuperHZ-L" manufactured by Tosoh Corporation + "TSK gel SuperHZM-N" manufactured by Tosoh Corporation + "TSK gel SuperHZM-N" manufactured by Tosoh Corporation + "TSK gel SuperHZM-N" manufactured by Tosoh Corporation + "TSK gel SuperHZM-N" manufactured by Tosoh Corporation
Detector: RI (differential refractometer)
Data processing: "EcoSEC Data Analysis Version 1.07" manufactured by Tosoh Corporation
Column temperature: 40°C
Developing solvent: tetrahydrofuran
Flow rate: 0.35 mL/min
Measurement sample: A measurement sample was prepared by dissolving 7.5 mg of sample in 10 mL of tetrahydrofuran and filtering the resultant solution with a microfilter.
Sample injection amount: 20 µL
Standard sample: Monodisperse polystyrene below having known molecular weights was used according to the measurement manual of "HLC-8420GPC".

### (Monodisperse polystyrene)

"A-300" manufactured by Tosoh Corporation
"A-500" manufactured by Tosoh Corporation
"A-1000" manufactured by Tosoh Corporation
"A-2500" manufactured by Tosoh Corporation
"A-5000" manufactured by Tosoh Corporation
"F-1" manufactured by Tosoh Corporation
"F-2" manufactured by Tosoh Corporation
"F-4" manufactured by Tosoh Corporation
"F-10" manufactured by Tosoh Corporation
"F-20" manufactured by Tosoh Corporation
"F-40" manufactured by Tosoh Corporation
"F-80" manufactured by Tosoh Corporation
"F-128" manufactured by Tosoh Corporation
"F-288" manufactured by Tosoh Corporation

### (EXAMPLE 1: synthesis of compound (1) having living polymer blocks at both ends of silicone chain)

In a glass flask provided with a stirrer, a thermometer, a condenser, and a dropping device, 35.10 g of n-heptane as a solvent, 70.00 g a silicone compound having hydroxyl groups at both ends represented by formula (a-1) below, and 9.81 g of triethylamine as a catalyst were charged, and the temperature in the flask was increased to 40°C.

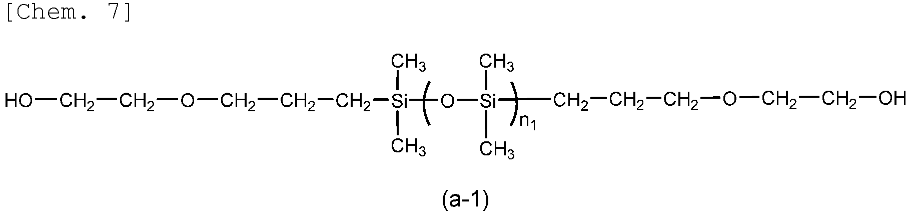

(In the formula, n₁ is 65 on average.

The molecular weight (Mn) of the silicone chain is 5,000.)

Then, 11.89 g of 2-bromoiosbutyric acid bromide was charged to the resultant mixture and stirred at room temperature for 3 hours. Then, 87.73 g of isopropyl ether and 105 g of a 10% aqueous citric acid solution were mixed and stirred and then allowed to stand, separating and removing an aqueous citric acid solution layer.

Next, 105 g of a 1% aqueous sodium hydroxide solution was mixed and stirred and then allowed to stand, separating and removing a 1% aqueous sodium hydroxide solution layer. Further, 105 g of 10% saline solution was mixed and stirred and then allowed to stand, separating and removing a 10% saline solution layer. Then, the solvent was distilled off under reduced pressure, producing a compound represented by formula (A-1) below.

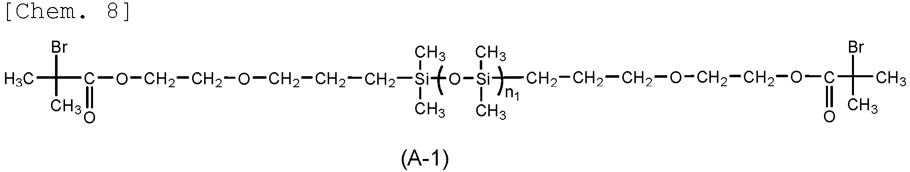

In a flask relaced with nitrogen, 3.10 g polypropylene glycol monomethacrylate (average number of repetitions of propylene glycol: 4 to 6) and 10.00 g of methyl ethyl ketone as a solvent were charged and heated to 60°C under stirring in a nitrogen stream. Next, 0.67 g of 2,2'-bipyridyl as a catalyst and 0.19 g of cuprous chloride were charged and stirred for 30 minutes while the inside of the flask was maintained at 60°C. Then, 5.00 g of a compound represented by the formula (A-1) was added, and living polymerization was performed for 27 hours at 60°C in a nitrogen stream.

Then, 30 g of activated alumina was added as a polymerization initiator to the resultant reaction product and stirred. After the activated alumina was filtered off, the solvent was distilled off under reduced pressure, producing a compound (1) having a living polymer block of a polymerizable monomer (poly(propylene glycol) monomethacylate) at either end of the silicone chain.

As a result of GPC measurement of the molecular weight of the resultant compound (1), the weight-average molecular weight (Mw) was 12,100, the number-average molecular weight (Mn) was 8,400, and (Mw/Mn) was 1.4.

Also. The ratio of the silicone chain in the compound (1) was 57% by mass.

### (EXAMPLE 2: synthesis of compound (2) having living polymer blocks at both ends of silicone chain)

In a flask relaced with nitrogen, 9.00 g polypropylene glycol monomethacrylate (average number of repetitions of propylene glycol: 4 to 6) and 14.35 g of methyl ethyl ketone as a solvent were charged and heated to 60°C under stirring in a nitrogen stream. Next, 0.67 g of 2,2'-bipyridyl as a catalyst and 0.19 g of cuprous chloride were charged and stirred for 30 minutes while the inside of the flask was maintained at 60°C. Then, 5.00 g of a compound represented by the formula (A-1) was added as a polymerization initiator, and living polymerization was performed for 54 hours at 60°C in a nitrogen stream.

Then, 30 g of activated alumina was added to the resultant reaction product and stirred. After the activated alumina was filtered off, the solvent was distilled off under reduced pressure, producing a compound (2) having a living polymer block of a polymerizable monomer (poly(propylene glycol) monomethacrylate) at either end of the silicone chain.

As a result of GPC measurement of the molecular weight of the resultant compound (2), the weight-average molecular weight (Mw) was 16,300, the number-average molecular weight (Mn) was 11,200, and (Mw/Mn) was 1.5.

Also. The ratio of the silicone chain in the compound (2) was 33% by mass.

### (EXAMPLE 3: synthesis of compound (3) having living polymer blocks at both ends of silicone chain)

In a glass flask provided with a stirrer, a thermometer, a condenser, and a dropping device, 100.00 g of n-heptane as a solvent, 200.00 g a silicone compound having hydroxyl groups at both ends represented by formula (a-2) below, and 12.45 g of triethylamine as a catalyst were charged, and the temperature in the flask was increased to 40°C.

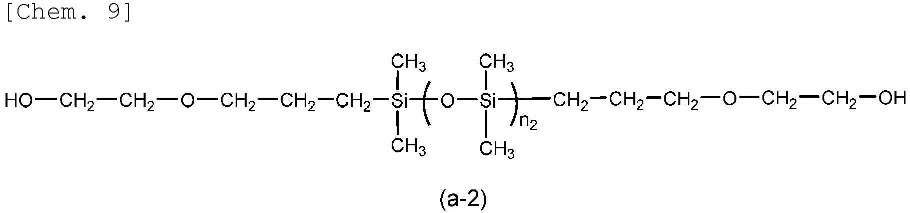

(In the formula, n₂ is 130 on average.

The molecular weight (Mn) of the silicone chain is 10,000.)

Then, 15.10 g of 2-bromoiosbutyric acid bromide was charged to the resultant mixture and stirred at room temperature for 3 hours. Then, 250.00 g of isopropyl ether and 300 g of a 10% aqueous citric acid solution were mixed and stirred and then allowed to stand, separating and removing an aqueous citric acid solution layer. Then, 300 g of a 1% aqueous sodium hydroxide solution was mixed and stirred and then allowed to stand, separating and removing a 1% aqueous sodium hydroxide solution layer. Further, 300 g of 10% saline solution was mixed and stirred and then allowed to stand, separating and removing a 10% saline solution layer.

Then, the solvent was distilled off under reduced pressure, producing a compound represented by formula (A-2) below.

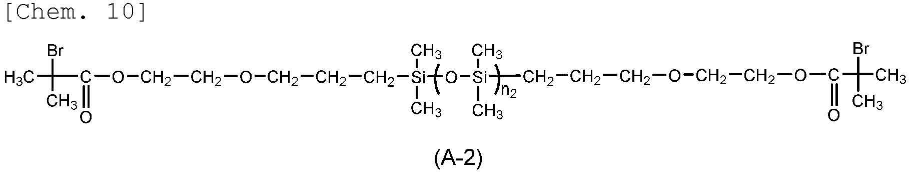

In a flask relaced with nitrogen, 20.00 g polypropylene glycol-polybutylene glycol monomethacrylate (average number of repetitions of propylene glycol: 1, average number of repetitions of butylene glycol: 6) and 73.00 g of methyl ethyl ketone as a solvent were charged and heated to 60°C under stirring in a nitrogen stream. Next, 0.63 g of 2,2'-bipyridyl as a catalyst and 0.18 g of cuprous chloride were charged and stirred for 30 minutes while the inside of the flask was maintained at 60°C. Then, 10.00 g of a compound represented by the formula (A-2) was added as a polymerization initiator, and living polymerization was performed for 74 hours at 60°C in a nitrogen stream.

Then, 20 g of activated alumina was added to the resultant reaction product and stirred. After the activated alumina was filtered off, the solvent was distilled off under reduced pressure, producing a compound (3) having a living polymer block of a polymerizable monomer (polypropylene glycol-polybutylene glycol monomethacylate) at either end of the silicone chain.

As a result of GPC measurement of the molecular weight of the resultant compound (3), the weight-average molecular weight (Mw) was 27,600, the number-average molecular weight (Mn) was 19,500, and (Mw/Mn) was 1.4.

Also. The ratio of the silicone chain in the compound (3) was 32% by mass.

### (COMPARATIVE EXAMPLE 1: synthesis of compound (1') having free-radical polymer block at either end of silicone chain)

Mixture A was prepared by mixing 102.6 g of polypropylene glycol monomethacrylate (average number of repetitions of propylene glycol: 4 to 6), 152. 6 g of butyl acetate as a solvent, and 13.5 g of tert-butylperoxy-2-ethyl hexanoate as an initiator.

Mixture B was prepared by mixing 47.4 g of a dimethacrylate compound having a polysiloxane bond represented by formula (A-1') below and 47.4 g of butyl acetate was a solvent.

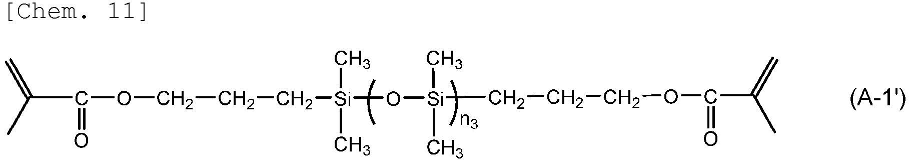

(In the formula, n₃ is 65 on average.

The molecular weight (Mn) of a silicone chain is 5,000.)

In a glass flask provided with a stirrer, a thermometer, a condenser, and a dropping device, 150.0 g of butyl acetate as a solvent was charged and heated to 105°C under stirring in a nitrogen stream.

The mixture A was dropped in the glass flask at 105°C over 140 minutes. The mixture B was dropped at 105°C over 120 minutes 5 minutes after the start of dropping of the mixture A. After the completion of dropping, the resultant mixture was stirred at 105°C for 5 hours. After the completion of reaction, the solvent was distilled off, producing a compound (1') having a free-radical polymer block of a polymerizable monomer at either end of the silicone chain.

As a result of GPC measurement of the molecular weight of the resultant compound (1'), the weight-average molecular weight (Mw) was 6,500, the number-average molecular weight (Mn) was 1,900, and (Mw/Mn) was 3.4.

Also. The ratio of the silicone chain in the compound (1') was 30% by mass.

### (COMPARATIVE EXAMPLE 2: synthesis of compound (2') having free-radical polymer blocks at both ends of silicone chain)

In a glass flask provided with a stirrer, a thermometer, a condenser, and a dropping device, 150.0 g of butyl acetate as a solvent was charged and heated to 105°C under stirring in a nitrogen stream.

The mixture A was dropped in the glass flask at 105°C over 140 minutes. The mixture B was dropped at 105°C over 120 minutes 5 minutes after the start of dropping of the mixture A. After the completion of dropping, the resultant mixture was stirred at 105°C for 10 hours. After the completion of reaction, the solvent was distilled off, producing a compound (2') having a free-radical polymer block of a polymerizable monomer at either end of the silicone chain.

As a result of GPC measurement of the molecular weight of the resultant compound (2'), the weight-average molecular weight (Mw) was 7000, the number-average molecular weight (Mn) was 2,000, and (Mw/Mn) was 3.5.

Also. The ratio of the silicone chain in the compound (2') was 30% by mass.

Evaluation below was performed by using the compounds produced in the examples and the comparative examples.

### (Formation and evaluation of coating film)

A resist composition (the content of the compound (1) was 0.05% by mass in terms of solid content) was prepared by mixing 3.0 g of a 40 mass% resin solution of an alkali-soluble resin (Acrydic ZL-295, manufactured by DIC Corporation), 1.2 g of Aronix M-402 (manufactured by Toagosei Chemical Co., Ltd., a mixture of dipentaerythritol pentaacrylate and dipentaerythritol hexaacrylate), 0.0024 g in terms of solid content of the compound (1), and 6.23 g of propylene glycol monomethyl ether acetate (PGMEA).

Then, 3 ml of the resultant resist composition was dropped on a central portion of a chromium-plated glass substrate of 10 cm × 10 cm, spin-coated under the conditions including a rotational speed of 400 rpm and a rotation time of 20 seconds, forming a coated substrate. SUS-made pins were provided at the four corners of a hot plate, and the resultant coated substrate was placed on the support pins and dried by heating at 100°C for 100 seconds, forming a laminate having a coating film layer.

### (Evaluation of smoothness)

The coating film layer of the resultant laminate was visually observed and the smoothness of the coating film layer was evaluated according to criteria below. The results are shown in Table 1.
A: No unevenness is observed in the coating film.
B: Substantially no unevenness is observed in the coating film.
C: Unevenness is observed over the whole of the coating film.

### (Evaluation of pin unevenness)

In the laminate formed as described above, the contact portion between each of the support pins and the coated substrate was visually observed, and pin unevenness of the coating film layer was evaluated according to criteria below. The "pin unevenness" represents film thickness unevenness (drying unevenness) produced around, as a center, a contact portion between each of the support pins and the coated substrate, and is confirmed in a form like ripples spreading around, as a center, a contact portion between each of the support pins and the coated substrate.
1: Substantially no pin unevenness is observed.
2: Pin unevenness is observed.

The same evaluation was performed by using the compounds of Examples 2 and 3 and Comparative Examples 1 and 2 in place of the compound (1). The results are shown in Table 1.

**[Table 1]**

| | Example 1 | Example 2 | Example 3 | Comparative Example 1 | Comparative Example 2 |
|---|---|---|---|---|---|
| Smoothness | A | A | A | C | C |
| Pin unevenness | 1 | 1 | 1 | 2 | 2 |

It was confirmed that with the compounds of Examples 1 to 3, smoothness is obtained by adding the resist composition having a solid content of as small as 0.05% by mass, and pin unevenness can be suppressed. On the other hand, with the compounds of Comparative Examples 1 and 2, both smoothness and the suppressed of pin unevenness are not obtained. In order to obtain smoothness by the compounds of Comparative Examples 1 and 2, the resist composition having a solid content of 0.4% by mass is required.

## Claims

1. A compound comprising a polymer block of a polymerizable monomer at each of both ends of a silicone chain,
wherein dispersity (Mw/Mn) which is the ratio of the weight-average molecular weight to the number-average molecular weight is within a range of 1.0 to 2.0.

2. The compound according to Claim 1, wherein the silicone chain is a silicone chain represented by formula (1) below, 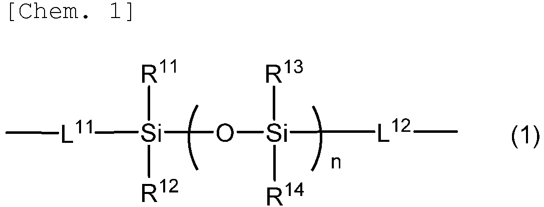 (in the formula (),
R¹¹, R¹², R¹³, and R¹⁴ are each independently an alkyl group having 1 to 18 carbon atoms or a phenyl group;
L¹¹ and L¹² are each independently a divalent organic group or a single bond; and
n is an integer).

3. The compound according to Claim 1 or 2, wherein the polymerizable monomer is a polymerizable monomer (2) having one or more selected from the group consisting of an alkyl group having 1 to 18 carbon atoms, an aromatic group having 6 to 18 carbon atoms, and a group containing a polyoxyalkylene chain, and a group containing a polyester chain.

4. The compound according to any one of Claims 1 to 3,
wherein the polymerizable monomer is one or more selected from the group consisting of a compound represented by formula (2-1) below, a compound represented by formula (2-2) below, a compound represented by formula (2-3) below, and a compound represented by formula (2-4) below, 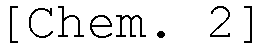 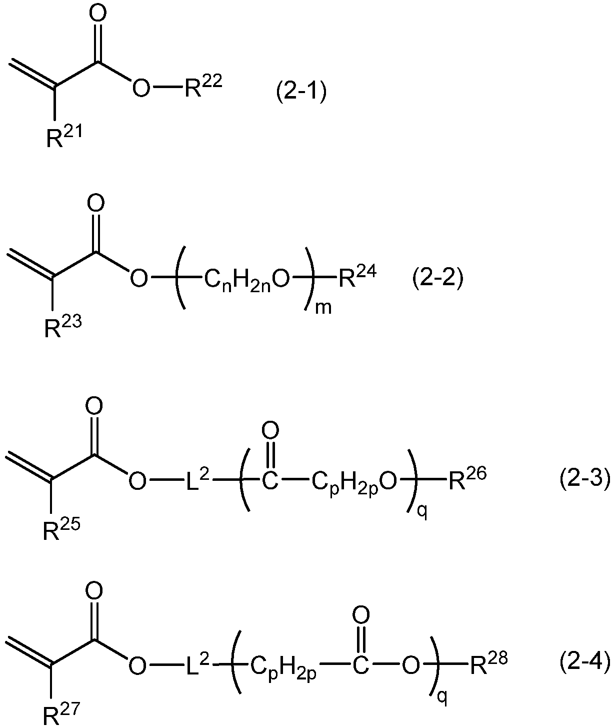 (in the formulae (2-1), (2-2), (2-3), and (2-4),
R²¹ is a hydrogen atom or a methyl group;
R²² is an alkyl group having 1 to 18 carbon atoms;
R²³ is a hydrogen atom or a methyl group;
R²⁴ is a hydrogen atom or an alkyl group having 1 to 18 carbon atoms;
R²⁵ is a hydrogen atom or a methyl group;
R²⁶ is an alkyl group having 1 to 18 carbon atoms or an alkyl group having 1 to 18 carbon atoms and an ether bond;
R²⁷ is a hydrogen atom or a methyl group;
R²⁸ is an alkyl group having 1 to 18 carbon atoms or an alkyl group having 1 to 18 carbon atoms and an ether bond;
L² is a divalent organic group or a single bond;
n is an integer within a range of 1 to 4; m is an integer within a range of 1 to 200; p is an integer within a range of 1 to 10; and q is an integer within a range of 1 to 100).

5. The compound according to any one of Claims 1 to 4,
wherein the compound contains as the polymerizable monomer one or more selected from the group consisting of a compound represented by the formula (2-2), a compound represented by the formula (2-3), and a compound represented by the formula (2-4) .

6. The compound according to any one of Claims 1 to 5,
wherein the number-average molecular weight of the silicone chain is within a range of 1,000 to 15,000.

7. The compound according to any one of Claims 1 to 6,
wherein the ratio of the silicone chain in the whole of the compound is 5% to 70% by mass.

8. A method for producing a compound having a living polymer block of a polymerizable monomer at each of both ends of a silicone chain, the method comprising:
generating radicals from a compound (1) having a functional group having the radical generating ability at each of both ends of a silicone chain in a reaction system containing the compound (1) and a polymerizable monomer (2), and performing living radical polymerization of the polymerizable monomer (2) at both ends of the compound (1).

9. The method for producing a compound according to Claim 8, wherein the compound (1) is a compound represented by formula (1-1) below having a functional group having the radical generating ability represented by formula (X-1)
below, 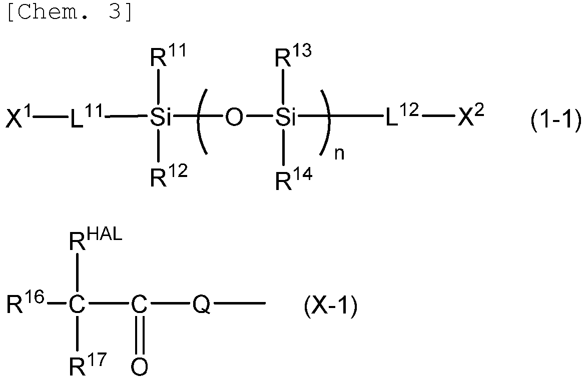 (in the formulae (1-1) and (X-1),
R¹¹, R¹², R¹³, and R¹⁴ are each independently an alkyl group having 1 to 18 carbon atoms or a phenyl group;
L¹¹ and L¹² are each independently a divalent organic group or a single bond;
n is an integer;
X¹ and X² are each independently the functional group having the radical generating ability represented by the formula (X-1);
R^{HAL} is a halogen atom;
R¹⁶ and R¹⁷ are each independently an alkyl group having 1 to 6 carbon atoms; and
Q is an oxygen atom or a sulfur atom).

10. The method for producing a compound according to Claim 8 or 9, wherein the polymerizable monomer (2) is one or more selected from the group consisting of a compound represented by formula (2-1) below, a compound represented by formula (2-2) below, a compound represented by formula (2-3) below, and a compound represented by formula (2-4), 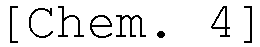 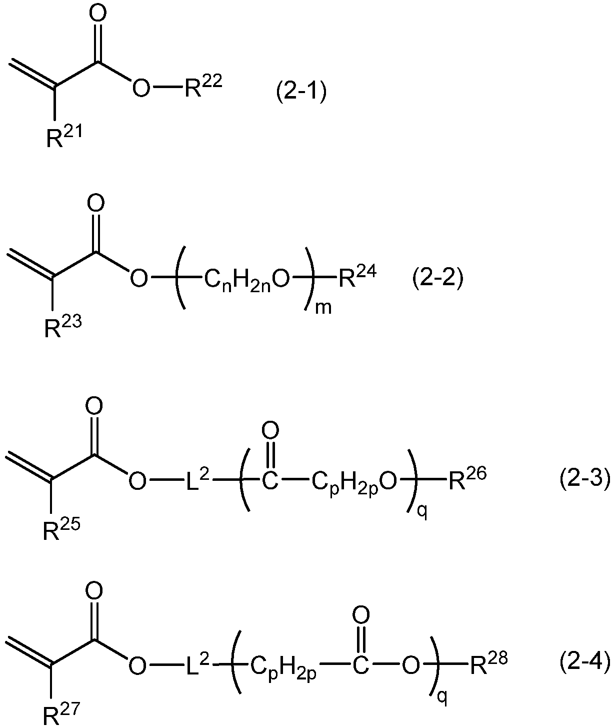 (in the formulae (2-1), (2-2), (2-3), and (2-4),
R²¹ is a hydrogen atom or a methyl group;
R²² is an alkyl group having 1 to 18 carbon atoms;
R²³ is a hydrogen atom or a methyl group;
R²⁴ is a hydrogen atom or an alkyl group having 1 to 18 carbon atoms;
R²⁵ is a hydrogen atom or a methyl group;
R²⁶ is an alkyl group having 1 to 18 carbon atoms or an alkyl group having 1 to 18 carbon atoms and an ether bond;
R²⁷ is a hydrogen atom or a methyl group;
R²⁸ is an alkyl group having 1 to 18 carbon atoms or an alkyl group having 1 to 18 carbon atoms and an ether bond;
L² isa divalent organic group or a single bond; and
n is an integer within a range of 1 to 4; m is an integer within a range of 1 to 200; p is an integer within a range of 1 to 10; and q is an integer within a range of 1 to 100) .

11. The method for producing a compound according to any one of Claims 8 to 10, wherein living radical polymerization is atom transfer radical polymerization performed using the compound (1) as a polymerization initiator in the presence of a compound having a transition metal compound and a ligand capable of coordinate-bonding to the transition metal.

12. A leveling agent comprising the compound according to any one of Claims 1 to 7.

13. A coating composition comprising the compound according to any one of Claims 1 to 7.

14. A resist composition comprising the compound according to any one of Claims 1 to 7.

15. A cured product comprising a cured product of the coating composition according to Claim 13 or the resist composition according to Claim 14.

16. An article comprising the compound according to any one of Claims 1 to 7.
